# EUROPÄISCHE PATENTSCHRIFT

(11) **EP 2 844 784 B1**
(45) Veröffentlichungstag und Bekanntmachung des Hinweises auf die Patenterteilung: **20.07.2022**
(21) Anmeldenummer: 13719098.9
(22) Anmeldetag: 26.04.2013
(51) Int. Cl.: H01L 51/00, H01L 51/52, H01L 51/56, H01L 51/54, C23C 16/40, C23C 16/54, H01L 21/02

(54) **VORRICHTUNG UND VERFAHREN ZUR OBERFLÄCHENBEHANDLUNG EINES SUBSTRATS UND VERFAHREN ZUM HERSTELLEN EINES OPTOELEKTRONISCHEN BAUELEMENTS**
DEVICE AND METHOD FOR THE SURFACE TREATMENT OF A SUBSTRATE AND METHOD FOR PRODUCING AN OPTOELECTRONIC COMPONENT
DISPOSITIF ET PROCÉDÉ DE TRAITEMENT DE LA SURFACE D'UN SUBSTRAT ET PROCÉDÉ DE FABRICATION D'UN COMPOSANT OPTOÉLECTRONIQUE

(30) Priorität: 30.04.2012 DE 102012207172
(43) Veröffentlichungstag der Anmeldung: 11.03.2015
(73) Patentinhaber: Fraunhofer Gesellschaft e.V., 80686 München (DE)
(72) Erfinder: BAUER, Jürgen, 82407 Wielenbach (DE); VOLLKOMMER, Frank, 82131 Gauting (DE); DÖLL, Gerhard, 86153 Augsburg (DE); BAUER, Klaus-Dieter, 94405 Landau (DE); ERHARD, Philipp, 86415 Mering (DE)
(74) Vertreter: Lux, Berthold
(86) Internationale Anmeldenummer: PCT/EP2013/058741
(87) Internationale Veröffentlichungsnummer: WO 2013/164268

(56) Entgegenhaltungen:
- EP-A1- 2 360 293
- DE-A1- 2 141 723
- US-A- 3 735 728
- US-A- 3 866 565
- US-A1- 2011 076 421
- POODT PAUL ET AL: "Spatial atomic layer deposition: A route towards further industrialization of atomic layer deposition", JOURNAL OF VACUUM SCIENCE AND TECHNOLOGY: PART A, AVS /AIP, MELVILLE, NY., US, Bd. 30, Nr. 1, 14. Dezember 2011 (2011-12-14), Seiten 10802-10802, XP012160310, ISSN: 0734-2101, DOI: 10.1116/1.3670745 [gefunden am 1901-01-01]

## Beschreibung

Die Erfindung betrifft eine Vorrichtung und ein Verfahren zur Oberflächenbehandlung eines Substrats und ein Verfahren zum Herstellen eines optoelektronischen Bauelements.

Elektronische Bauteile auf Substraten, beispielsweise auf flexiblen Substraten, deren funktionelle Schichten aus organischen und/oder organometallischen Materialien aufgebaut sind, werden häufig vor Sauerstoff und Wasser geschützt. Beispielsweise weisen opto-elektronische Bauelemente mit organischen funktionellen Schichten häufig Verkapselungsschichten unter und/oder über den organischen funktionellen Schichten auf, die die organischen funktionellen Schichten schützen, beispielsweise vor Feuchtigkeit. Die Verkapselungsschichten werden beispielsweise mittels Abscheideverfahren aufgebracht, beispielsweise mittels Atomschichtenabscheidung oder chemischer Gasphasenabscheidung. Beispiele für derartige Systeme sind optoelektronische Bauelemente, beispielsweise Licht absorbierende oder Licht emittierende Zellen wie z.B. elektrochemische Zellen und OLEDs, aber auch organische Solarzellen. Bei all diesen Systemen hängt die Lebensdauer und Performance ganz wesentlich von der Qualität der Verkapselung ab.

Bei einer herkömmlichen Vorrichtung zur Oberflächenbehandlung eines Substrats oder einem entsprechenden Verfahren, insbesondere bei einem Beschichtungsverfahren zum Herstellen eines optoelektronischen Bauelements, das das Substrat aufweist, kann das Substrat mit unterschiedlichen Schichten, beispielsweise den organisch funktionellen Schichten und/oder den Verkapselungsschichten beschichtet werden. Diese Schichten können nur wenige Atomlagen aufweisen oder bis hin zu einigen hundert Nanometern dick sein. Die Schichten können beispielsweise mit CVD-(Chemical Vapour Deposition) Verfahren oder ALD-(Atomic Layer Deposition) Verfahren aufgebracht werden. Nachteil dieser Verfahren, beispielsweise des ALD-Verfahrens, ist allerdings die recht zeitaufwendige Prozessierung, die Schichtwachstumsraten von ca. 1 Ä pro Beschichtungsprozess aufweisen. Aus diesem Grunde werden am häufigsten Beschichtungen von Substratverbänden (Losen, Batches) in größeren ALD-Reaktoren mit entsprechenden Prozessräumen zum Aufnehmen der Substratverbände vorgenommen, bei denen mehrere Bauteile gleichzeitig während mehrerer Stunden beschichtet werden. Dabei werden die Substrate beispielsweise in einem großen Substratverband beschichtet, aus dem in einem nachfolgenden Prozess die einzelnen Substrate vereinzelt werden, beispielsweise ist der Substratverband ein Wafer oder eine Substratplatte. Zusätzlich kann eine Verkapselung mittels Glasplatten erfolgen.

Das zu beschichtende Substrat, beispielsweise in dem Substratverband, kann in den Prozessraum eingebracht werden, dem nacheinander ein, zwei oder mehrere Prozessgase zugeführt werden. Die Prozessgase weisen beispielsweise Reaktionsgase auf und dienen dazu, Atome und/oder Moleküle auf dem Substrat abzulagern und durch Reaktion die Schichten zu bilden, und/oder die Prozessgase weisen ein Spülgas auf, das dazu dient, den Prozessraum zu spülen, um nachfolgend ein Reaktionsgas einbringen zu können, das sich mit einem zuvor eingebrachten Reaktionsgas nicht mischen darf oder das zumindest nur auf der Oberfläche des Substrats eine Verbindung mit Atomen oder Molekülen des zuvor eingebrachten Reaktionsgases eingehen darf, wie beispielsweise bei dem ALD-Prozess. Ferner können die Reaktionsgase Mischgase sein, die ein reaktives Gas und ein Trägergas aufweisen. Zwischen den einzelnen Prozessschritten, bei denen Prozessgase dem Prozessraum zugeführt werden, können ein, zwei oder mehr Prozessschritte durchgeführt werden, bei denen die zugeführten Prozessgase wieder abgesaugt werden und/oder ein Unterdruck in dem Prozessraum erzeugt wird. Beispielsweise kann dies immer vor und nach dem Zuführen des Spülgases erfolgen.

Bei einem Beschichten einer großen Menge von Substraten treten nun mehrere Probleme auf. Beispielsweise können nur eine begrenzte Menge von Substraten in den Prozessraum eingebracht werden. Außerdem kann es je nach Beschichtungsprozess erforderlich sein, dem Prozessraum zum Beschichten der Menge von Substraten mehrmals das gleiche und/oder unterschiedliche Prozessgase zuzuführen und diese zwischendurch immer wieder abzusaugen, wobei ein Verlust an Prozessgas entsteht. Außerdem können in Bereichen (Toträumen), die außerhalb der vorwiegenden Gasströmung liegen, durch den dort erschwerten Gasaustausch lange Prozesszeiten und/oder Qualitätsprobleme durch Verunreinigungen entstehen. Ferner entsteht ein großer Schaden, falls ein Prozessschritt fehlerhaft ist, da die gesamte Menge von Substraten oder der gesamte Substratverband betroffen sein kann und danach nicht mehr verwendet werden kann. Des Weiteren führt das ständige Einlegen und Herausnehmen der Substrate in bzw. aus dem Prozessraum und das gegebenenfalls häufige Füllen und Absaugen des Prozessraumes zu einer langen Prozessdauer beim Beschichten der Substrate.

Es ist bekannt, als Alternative zu dem ortsfesten Prozessraum zum Vermeiden der genannten Nachteile bewegliche Prozessköpfe zu verwenden. Insbesondere bei der Herstellung flexibler Solarzellen und flexibler Licht emittierender Systeme versucht man beispielsweise Roll-to-Roll (R2R) Verfahren einzusetzen, bei denen ein Substrat oder Substratverband von einer Rolle abgerollt wird, am Stück behandelt wird und nach dem Behandeln wieder auf eine Rolle aufgerollt wird oder vereinzelt wird, um effizienter und kostengünstiger produzieren zu können. Natürlich sollten beispielsweise auch die Verkapselungen möglichst kompatibel mit diesen Prozessen ausgeführt werden.

Bei flexiblen Systemen möchte man häufig die Flexibilität nicht durch eine Glasverkapselung verlieren. Daher werden zur Verkapselung häufig dünne geschlossene Schichten verwendet. Zur Herstellung dieser Schichten wird in der Literatur häufig das ALD Verfahren genannt, da man dadurch dichte und konformale, d.h. auch dreidimensionale Strukturen umschließende Schichten herstellen kann. Beim ALD Verfahren handelt es sich um ein Verfahren, bei dem jeweils eine Atomlage einer Schicht, beispielsweise einer Metalloxidschicht aufgebracht wird. Dies geschieht, indem mit einem ersten Reaktionsgas (z.B. Wasserdampf), das auch Precursor 1 oder erstes Edukt genannt wird, die Oberfläche des zu beschichtenden Substrates belegt wird. Nach Abpumpen des ersten Eduktes verbleibt auf der Oberfläche eine Monolage des adsorbierten ersten Eduktes. Nachfolgend wird ein zweites Reaktionsgas (z.B. TMA, Trimethylaluminium) zugeführt, das auch Precursor 2 oder zweites Edukt genannt wird. Dieses reagiert nun mit dem auf der Oberfläche verbliebenen ersten Edukt und bildet auf der Oberfläche eine monoatomare Lage des entsprechenden Feststoff-Reaktionsproduktes, z.B. eines Metalloxids (Al2O3). Zwischen dem Zuführen der unterschiedlichen Reaktionsgase muss der Prozessraum abgepumpt und/oder mit einem inerten Gas gespült werden, um gasförmige Reaktionsprodukte und unreagierte Reste des jeweiligen Precursors zu entfernen. Dadurch wird auch eine Vermischung von Precursor 1 und Precursor 2 und eine ungewünschte Reaktion der beiden Substanzen in der Gasphase vermieden.

Zur schnellen ALD-Beschichtung flexibler Substrate sind verschiedene Ansätze bekannt:
Beispielsweise kann ein ALD-Beschichtungsprozesskopf schlitzförmige Gasauslässe aufweisen, die zur Beströmung des Substrates mit den Precusoren dienen (siehe "Towards a Roll-to-Roll ALD-Process, D. Cameron et al., ASTRal, MIICS 2010, Seite 15). Der Kopf trägt neben den Gasauslässen für die Precursoren auch Gasauslässe für ein Spülgas, sowie Gaseinlässe zum Absaugen der unterschiedlichen Gase. Dieser Beschichtungskopf wird nun relativ zum Substrat lateral abwechselnd und vorwärts/rückwärts bewegt (auch Bewegungen quer zum Substrat sind natürlich denkbar). Ein Bewegungszyklus entspricht zwei Schichtwachstumszyklen, da mit jeder Bewegung beide Precusoren aufgebracht werden, die zusammen eine Schicht bilden. Die Notwendigkeit der Beschichtungsrichtungsumkehr ist stets mit positiven und negativen Beschleunigungen verbunden. Zu akzeptablen Beschichtungsgeschwindigkeiten kann man daher nur durch lange große Anlagen kommen. Großer Platzbedarf bedeutet aber automatisch schwerer zu kontrollierende Partikelfreiheit und im Falle eines fest stehenden ALD-Beschichtungsprozesskopfes lange Gaszuleitungen oder aber einen hohen Aufwand in der Bandführung und Bandbewegung des flexiblen Substrates. Kompakte ALD-Beschichtungseinheiten mit hohem Durchsatz können daher mit dieser Methode nicht realisiert werden. Außerdem können Beschleunigungsstrecken, beispielsweise an vorderen und hinteren oder seitlichen Umkehrpunkten des Prozesskopfes, möglicherweise zu Inhomogenitäten in der Schichtqualität führen.

Als Alternative ist aus der vorstehend genannten Veröffentlichung eine ALD-Prozesseinheit bekannt, die einen radialsymmetrischem Beschichtungsprozesskopf zeigt, dessen Gasauslässe in Richtung Zentrum zeigen. Von einem Substratverband, der beispielsweise ein Endlos-Substrat aufweist, das auf einer Rolle aufgewickelt ist, wird ein Substratabschnitt vereinzelt, dessen Länge etwas kürzer ist, als ein Innenumfang des Beschichtungskopfes. Der vereinzelte Substratabschnitt wird auf einen kreisförmigen Substrathalter gespannt, der innerhalb des Prozesskopfes angeordnet ist. Dann wird der Substrathalter mit dem Substratabschnitt gedreht und dabei mit Hilfe des Prozesskopfes beschichtet, wobei bei einer Umdrehung beispielsweise ein, zwei oder mehr gleiche oder unterschiedliche Schichten auf den Substratabschnitt aufgebracht werden können. So können bei einer hohen Umdrehungszahl schnell viele Schichten auf den Substratabschnitt aufgebracht werden. Nachteil der gezeigten Anordnung ist allerdings die Notwendigkeit, die flexiblen Substrate von der Rolle abrollen zu müssen, sie vereinzeln zu müssen und als bereits vereinzelte Substratabschnitte nacheinander auf einen innerhalb des Prozesskopfes koaxial rotierenden walzenförmigen Substrathalter aufspannen zu müssen. Damit wird der Roll-to-Roll Prozess aufgegeben, allerdings mit dem Vorteil, die Schichten wesentlich schneller aufbauen zu können. Die Beschichtungsgeschwindigkeit wird nämlich wesentlich durch die Rotationsgeschwindigkeit des Substrathalters vorgegeben. Des Weiteren entfallen Beschleunigungsstrecken, beispielsweise mit dem Wegfall von Umkehrpunkten.

Weitere aus der genannten Veröffentlichung bekannte Verfahren arbeiten mit unterschiedlichen Gaszonen. Nachteil hierbei ist die zuverlässige Vermeidung von Gasinterdiffusion, sowie die Notwendigkeit die zu beschichtenden Substrate in der Größenordnung von hundert mal oder mehr umlenken zu müssen, ohne die Schichten zu beschädigen oder zu kontaminieren.

Die US 2011/076421 A1 offenbart eine Vorrichtung zur Oberflächenbehandlung eines Substrats gemäß dem Oberbegriff des Anspruches 1. Die EP 2 360 293 A1 offenbart ein Verfahren zum Abscheiden einer Atomschicht auf einem Substrat, wobei das Verfahren das Zuführen eines Vorläufergases aus einer Vorläufergaszufuhr eines Abscheidungskopfes, der Teil einer drehbaren Trommel ist, und das Bewegen der Vorläufergaszufuhr durch Drehen des Abscheidungskopfes entlang des Substrats umfasst, das seinerseits entlang der rotierenden Trommel bewegt wird. Die DE 21 41 723 A1 betrifft eine VakuumBedampfungsanlage zur kontinuierlichen Bedampfung von Bändern, bei der ein Bedampfungsraum und ein durch eine Trennwand hiervon getrennter Umspulraum jeweils gesondert evakuierbar sind, wobei in der Aufdampfzone das zu bedampfende Band den Bedampfungsraum gegen den Umspulraum abtrennt und die Bandrückseite in der Aufdampfzone zum Umspulraum hin zumindest teilweise offenliegt. Die US 3 866 565 A beschreibt eine Vorrichtung zum Abscheiden eines Metalls auf einem Metallstreifen, bei dem eine am Umfang geschlitzte Trommel einen Behälter umschließt, in den das abzuscheidende Metall eingefüllt ist und zur Verdampfung erhitzt wird, und ein Metallstreifen entlang des Außenumfangs der Trommel bewegt wird. Die US 3 735 728 A offenbart eine Vorrichtung zur Dampfabscheidung, bei der ein Werkstoffstreifen innerhalb einer Vakuumumgebung über ein drehbares Maskierungsrad geführt wird, wobei die Verdampfungsquelle und das zu verdampfende und auf dem Streifen abzuscheidende Material sich innerhalb des Umfangs des Maskierungsrads befinden.

Die vorliegende Erfindung stellt eine Vorrichtung zur Oberflächenbehandlung eines Substrats gemäß Anspruch 1, ein Verfahren zur Oberflächenbehandlung eines Substrats gemäß Anspruch 16 und ein Verfahren zum Herstellen eines optoelektronischen Bauelements gemäß Anspruch 24 bereit.

In verschiedenen Ausführungsformen werden eine Vorrichtung und ein Verfahren zur Oberflächenbehandlung eines Substrats bereitgestellt, bei dem einfach und schnell eine Oberfläche des Substrats behandelt werden kann. Des Weiteren wird in verschiedenen Ausführungsformen ein Verfahren zum Herstellen eines optoelektronischen Bauelements bereitgestellt, bei dem eine Oberfläche des Substrats des optoelektronischen Bauelements einfach und schnell behandelt werden kann. Die Oberflächenbehandlung kann beispielsweise eine Beschichtung des Substrats aufweisen und/oder das Substrat kann ein flexibles Substrat sein und/oder das Verfahren kann Teil eines Roll-to-Roll-Verfahrens sein, beispielsweise zum Beschichten mehrerer Substrate, beispielsweise flexibler Substrate, beispielsweise ohne die flexiblen Substrate vorher vereinzeln zu müssen (R2R, kein Batch-Betrieb).

In verschiedenen Ausführungsformen wird eine Vorrichtung zur Oberflächenbehandlung eines Substrats bereitgestellt. Die Vorrichtung weist einen um eine Drehachse drehbar gelagerten Prozesskopf auf. Der Prozesskopf weist mehrere Gasauslässe auf, die zumindest teilweise an einem radial äußeren Rand des Prozesskopfes ausgebildet sind.

Die Gasauslässe an dem radial äußeren Rand ermöglichen, das Substrat am äußeren Rand des Prozesskopfes anzuordnen und/oder, im Falle eines flexiblen Substrats, das flexible Substrat zumindest teilweise um den radial äußeren Rand des Prozesskopfes herum geführt anzuordnen und die dem Prozesskopf zugewandte Seite des Substrats zu behandeln. Dies in Verbindung mit dem drehbar gelagerten Prozesskopf ermöglicht, ein Endlos-Substrat, beispielsweise eine Endlos-Folie, beispielsweise direkt an den Folienherstellungsprozess anschließend, nach und nach an dem äußeren Rand des Prozesskopfes vorbei zu führen, und das Endlos-Substrat zu behandeln. Dies ermöglicht, die Oberflächenbehandlung schnell, einfach und/oder beispielsweise in einem Roll-to-Roll-Verfahren durchzuführen. Beispielsweise kann bei der Oberflächenbehandlung das flexible Substrat beschichtet werden, beispielsweise in einem CVD-Prozess und/oder beispielsweise in einem ALD-Prozess. Die dafür nötigen Prozessgase können über die Gasauslässe am radial äußeren Rand zugeführt werden. Dass das Substrat flexibel ist, bedeutet beispielsweise, dass das Substrat zumindest teilweise um den Prozesskopf geführt werden kann, ohne dabei beschädigt zu werden. Dies kann beispielsweise auch von dem Radius des Prozesskopfes und der dadurch vorgegebenen Krümmung des Substrats abhängen.

Der drehbare Prozesskopf mit den Gasauslässen an dem radial äußeren Rand ermöglicht eine Oberflächenbehandlung des Substrats, beispielsweise des flexiblen Substrats, bei einem geringen Gasverbrauch und einer hohen Prozessgeschwindigkeit, insbesondere wenn pro Schicht mehrere Gase nacheinander benötigt werden und/oder wenn mehrere gleiche oder unterschiedliche Schichten übereinander auf- oder abgetragen werden müssen. Des Weiteren kann die Vorrichtung sehr kompakt ausgebildet werden und kann einfach in eine bestehende Produktionslinie eingefügt werden. Des Weiteren ist bei einer Fehlbehandlung nur ein kleiner Teil des flexiblen Substrats, insbesondere der an den Prozesskopf angelegte Teil, fehlerhaft und kann ohne großen Schaden entfernt werden.

Das flexible Substrat kann beispielsweise von einer Rolle abgerollt, mit Hilfe des Prozesskopfs behandelt und wieder auf eine andere Rolle aufgerollt werden, beispielsweise ohne einen Vereinzelungsprozess. Alternativ dazu kann das flexible Substrat direkt nach der Behandlung vereinzelt werden. Das flexible Substrat weist beispielsweise eine Capton-Folie, eine Metallfolie oder eine PET-Folie auf. Das flexible Substrat kann bereits beschichtet sein, beispielsweise mit einer organisch funktionellen Schichtenstruktur zum Emittieren oder Absorbieren von Licht, mit einer oder mehreren optisch funktionellen Schicht, wie Streuschichten oder Brechungsschichten, und/oder mit einer oder mehreren Elektrodenschichten. In anderen Worten kann bereits ein Stapel (Stack) von Schichten auf dem Substrat ausgebildet sein, der dann mit Hilfe des drehbaren Prozesskopfes beschichtet wird. Alternativ dazu können diese Schichten im Zuge der Oberflächenbehandlung auf das Substrat aufgebracht werden. In diesem Zusammenhang kann bei der Oberflächenbehandlung beispielsweise eine Verkapselungsschicht aufgebracht werden, beispielsweise gemäß einem ALD-Verfahren. Alternativ dazu können auch eine oder mehrere Barrierenschichten, optische Schichten und/oder ein oder mehrere Dünnschichttransistoren aufgebracht werden.

Gemäß verschiedenen Ausführungsformen sind die Gasauslässe so ausgebildet und angeordnet, im Betrieb ein Prozessgas zumindest einen der Gasauslässe so verlässt, dass es zumindest teilweise in einer Richtung mit einer radial gerichteten Richtungskomponente weg von dem Prozesskopf strömt. In anderen Worten strömt das Prozessgas aus dem Gasauslass bis hin zu dem flexiblen Substrat, wobei der Strom des Prozessgases direkt auf das Substrat gerichtet sein kann und/oder das Prozessgas kann auf den Prozesskopf selbst gelenkt werden und dann indirekt hin zu dem Substrat strömen. Dies trägt dazu bei, dass das um den äußeren Rand angeordnete flexible Substrat gleichmäßig beschichtet wird. Beispielsweise kann das Prozessgas in radialer Richtung, also senkrecht zur Drehachse aus dem Prozesskopf geblasen werden, das Prozessgas kann aber auch nur teilweise in radialer Richtung gerichtet aus dem Prozesskopf geblasen werden, beispielsweise unter Berücksichtigung einer Strömungsoptimierung bei sich drehendem Prozesskopf. Beispielsweise können die Gasauslässe strömungsoptimiert ausgebildet sein.

Gemäß verschiedenen Ausführungsformen ist der Prozesskopf zylinderförmig ausgebildet, beispielsweise gemäß einem geraden Zylinder, und weist eine Achse und eine Mantelfläche auf, wobei die Achse beispielsweise eine Gerade ist, die durch die Mittelpunkte der Grund- und Deckfläche des Zylinders verläuft. In anderen Worten kann der Prozesskopf trommelförmig ausgebildet sein. Die Achse liegt beispielsweise auf der Drehachse und die an dem äußeren Rand angeordneten Gasauslässe sind an der Mantelfläche ausgebildet. Dies ermöglicht auf einfache Weise, die Gasauslässe an dem radial äußeren Rand zu positionieren, das flexible Substrat um den radial äußeren Rand bzw. die Mantelfläche herum anzuordnen und die zu beschichtenden Oberfläche des flexiblen Substrats gleichmäßig zu beschichten. In axialer Richtung kann der Prozesskopf abhängig von der Breite des zu behandelnden Substrats beispielsweise zwischen 1 mm und 10000 mm, beispielsweise zwischen 10 mm u. 1000 mm, beispielsweise zwischen 100 mm u. 500 mm breit sein. Der Radius des Prozesskopfes kann beispielsweise zwischen 10 mm und 1000 mm, beispielsweise zwischen 100 mm und 600 mm betragen.

Gemäß verschiedenen Ausführungsformen ist mindestens ein Gaseinlass an dem radial äußeren Rand des Prozesskopfes ausgebildet. Dies ermöglicht, Prozessgas, das beispielsweise über die Gasauslässe zwischen das flexible Substrat und den Prozesskopf eingebracht wurde, wieder zu entfernen, beispielsweise abzusaugen. Der Gaseinlass an dem radial äußeren Rand kann gemäß einem der Gasauslässe oder unterschiedlich dazu ausgebildet sein, beispielsweise an der Mantelfläche des Prozesskopfes.

Gemäß verschiedenen Ausführungsformen sind mindestens ein Gasauslass und/oder der mindestens eine an dem radial äußeren Rand angeordnete Gaseinlass schlitzförmig und/oder kreisförmig ausgebildet. Beispielsweise kann der entsprechende Gasauslass bzw. Gaseinlass eine oder mehrere schlitzförmige bzw. kreisförmige Ausnehmung(en) in dem radial äußeren Rand, beispielsweise dem Mantel, aufweisen. Der Schlitz kann sich beispielsweise von einem axialen Ende des Prozesskopfes zu dem anderen axialen Ende des Prozesskopfes erstrecken, beispielsweise parallel zu der Drehachse und/oder tangential an die Mantelfläche des Prozesskopfes. Alternativ oder zusätzlich können mehrere kreisförmige Ausnehmungen beispielsweise entlang einer oder mehrerer Geraden von einem axialen Ende des Prozesskopfes zu dem anderen axialen Ende des Prozesskopfes angeordnet sein. Dies trägt dazu bei, dass die zu beschichtende Oberfläche des flexiblen Substrats gleichmäßig beschichtet wird. Alternativ dazu können ein, zwei oder mehr beispielsweise schlitzförmige oder kreisförmige Auslässe gemeinsam einen Gasauslass bilden. Ferner können die Ausnehmungen eckig und/oder strömungsoptimiert ausgebildet sein.

Gemäß verschiedenen Ausführungsformen weist der Prozesskopf einen ersten Gasauslass zum Zuführen eines ersten Reaktionsgases zu einem ersten Prozessraum, einen zweiten Gasauslass zum Zuführen eines zweiten Reaktionsgases zu einem zweiten Prozessraum auf und einen weiteren Gasauslass zum Zuführen eines Spülgases zu einem Spülbereich, der auch als weiterer Prozessraum bezeichnet werden kann. Die Reaktionsgase und das Spülgas können auch als Prozessgase bezeichnet werden. Zusätzlich kann der Prozesskopf um den Umfang umlaufend zwischen den Gasauslässen je einen, zwei oder mehrere der Gaseinlässe aufweisen, über die die Reaktionsgase und/oder das Spülgas abgesaugt werden. Dies ermöglicht, beispielsweise drei unterschiedliche Prozessgase zuzuführen, beispielsweise im Zuge eines ALD-Verfahrens als erstes Reaktionsgas ein erstes gasförmiges Edukt (Ausgangsstoff) und als zweites Reaktionsgas ein zweites gasförmiges Edukt zum Erzeugen einer Schicht aus einem ersten Material oder einer ersten Materialkombination und das Spülgas. Bei dem ALD-Prozess werden das erste und zweite gasförmige Edukt auch als erster bzw. zweiter Precursor bezeichnet. Darüber hinaus können noch weitere Gasauslässe vorgesehen sein, beispielsweise können zwei weitere Edukte zugeführt werden, beispielsweise zum Erzeugen einer Schicht aus einem zweiten Material oder einer zweiten Materialkombination, oder es können auch mehrere Gasauslässe zum Zuführen des ersten und/oder zweiten Edukts vorgesehen sein. Beispielsweise kann immer zwischen zwei Gasauslässen für die Edukte je ein Gasauslass für das Spülgas vorgesehen sein. Ferner kann zwischen den Gasauslässen der Edukte jeweils ein Gaseinlass zum Absaugen der Edukte vorgesehen sein. So können beispielsweise entlang des Umfangs des radial äußeren Rands nacheinander ein Gasauslass für das erste Edukt, ein Gaseinlass zum Absaugen des ersten Edukts, ein Gasauslass für das Spülgas, ein Gaseinlass zum Absaugen des Spülgases, ein Gasauslass für das zweite Edukt, ein Gaseinlass zum Absaugen des zweiten Edukts, wieder ein Gasauslass für das Spülgas und ein Gaseinlass zum Absaugen des Spülgases vorgesehen sein. Diese Reihenfolge kann mehrmals wiederholt werden und/oder es können noch weitere Gasauslässe für weitere Edukte und/oder weitere Gaseinlässe vorgesehen sein.

Gemäß verschiedenen Ausführungsformen weist die Vorrichtung ein Gehäuse auf, in dem der Prozesskopf drehbar gelagert ist und das eine Zuführöffnung zum Zuführen des Substrats, beispielsweise des flexiblen Substrats, und eine Abfuhröffnung zum Abführen des Substrats aufweist. Das Gehäuse ermöglicht beispielsweise, eine Umgebung der Vorrichtung vor den Prozessgasen zu schützen, den Prozessbereich zu temperieren und/oder das Substrat zu schützen. Im Bereich der Zuführöffnung und/oder im Bereich der Abfuhröffnung kann je ein Element einer Vorschubvorrichtung ausgebildet sein. Die Vorschubvorrichtung kann gegebenenfalls dazu beitragen, das Substrat in das Gehäuse hinein und/oder aus dem Gehäuse heraus zu schieben bzw. zu ziehen. Beispielsweise kann die Vorschubvorrichtung eine, zwei oder mehrere Walzen aufweisen, die beispielsweise aktiv oder passiv drehbar sind. Ferner kann die Vorschubvorrichtung so in dem Gehäuse integriert sein, dass sie einen Teil des Gehäuses und/oder der Zuführöffnung und/oder der Abfuhröffnung darstellt. Beispielsweise können die Zuführöffnung und/oder die Abfuhröffnung durch einen Schlitz zwischen je einer Walze der Vorschubvorrichtung und dem Gehäuse gebildet sein.

Gemäß verschiedenen Ausführungsformen weist die Vorrichtung eine Heizvorrichtung auf, die einen Innenraum des Gehäuses beheizt. Die Heizvorrichtung kann auf besonders einfache Weise dazu beitragen, eine Prozesstemperatur für die Oberflächenbehandlung zu erreichen, sofern der entsprechende Prozess dies erfordert. Beim Durchführen der Oberflächenbehandlung kann eine Temperatur in dem Gehäuse zwischen 0° und 1000° C erzeugt werden, beispielsweise zwischen 10° und 500° C, beispielsweise zwischen 20° und 250°, beispielsweise ungefähr 200° C. Alternativ dazu können Oberflächenbehandlungen bei Zimmertemperatur durchgeführt werden.

Gemäß verschiedenen Ausführungsformen weist die Vorrichtung eine Gehäuse-Absaugung zum Absaugen von Gas aus dem Gehäuse auf. Das Gas kann beispielsweise Luft oder Prozessgas aufweisen. Dies kann dazu beitragen, zu verhindern, dass Prozessgas in die Umgebung der Vorrichtung austritt. Die Gehäuse-Absaugung kann beispielsweise mehrere Absaugungen aufweisen, die beispielsweise ein stufenweises und/oder differentielles Absaugen des Gases ermöglichen. Durch eine sequentielle Anordnung von Absaugungen nach dem Prinzip des differentiellen Pumpens kann beispielsweise verhindert werden, dass Umgebungsluft in das Gehäuse eintritt, beispielsweise wenn der Gehäuseinnendruck unterhalb des Umgebungsdruckes liegt, oder Prozessgas aus dem Gehäuse austritt, beispielsweise wenn der Gehäuseinnendruck oberhalb des Umgebungsdruckes liegt. Die Gehäuse-Absaugung kann beispielsweise auf der zu beschichtenden Seite des Substrats oder auf der nicht zu beschichtenden Seite des Substrats erfolgen, beispielsweise im Bereich der Vorschubvorrichtung, zwischen den Zuführöffnungen oder im Bereich des Prozesskopfes. Ferner kann in dem Gehäuse eine Absaugung so angeordnet sein, dass diese auf der nicht zu beschichtenden Seite des Substrats einen Unterdruck erzeugt, so dass das Substrat von dem Prozesskopf weggesaugt wird und so einen vorgegebenen Abstand zu dem Prozesskopf hat.

Gemäß verschiedenen Ausführungsformen weist das Gehäuse eine Gehäuse-Spülgaszuführung zum Zuführen von Spülgas in das Gehäuse auf. In diesem Zusammenhang kann das Gehäuse beispielsweise mit Hilfe von erwärmtem Spülgas beheizt werden. Das Spülgas kann beispielsweise auf der zu beschichtenden Seite des Substrats oder auf der nicht zu beschichtenden Seite zugeführt werden, beispielsweise im Bereich der Vorschubvorrichtung, zwischen den Zuführöffnungen oder im Bereich des Prozesskopfes. Die Gehäuse-Spülgaszuführung kann beispielsweise mit der Absaugung zusammenwirken zum Schützen der Umgebung der Vorrichtung vor Prozessgasen.

Gemäß verschiedenen Ausführungsformen weist die Vorrichtung die Vorschubvorrichtung zum Vorschieben des Substrats, beispielsweise des flexiblen Substrats, hin zu dem Prozesskopf und zum Weiterführen des Substrats weg von dem Prozesskopf auf. Dies ermöglicht auf einfache Weise ein Roll-to-Roll Verfahren durchzuführen. Die Vorschubvorrichtung kann beispielsweise ein, zwei oder mehrere drehbare Rollen oder die vorstehend genannten Walzen aufweisen, deren Drehachsen beispielsweise parallel zu der Drehachse des Prozesskopfes ausgebildet sein können.

Der Prozesskopf weist zum Auflegen des Substrats auf den Prozesskopf zwei oder mehr Abstandshalter auf. Die Abstandshalter sind benachbart zu dem Prozesskopf ausgebildet. Beispielsweise können die Abstandshalter von dem Mantel des Prozesskopfs in radialer Richtung abstehen und sind relativ zu dem Prozesskopf drehbar gelagert. Im Betrieb wird das flexible Substrat zumindest teilweise so um den Prozesskopf geführt, dass es auf den Abstandshaltern aufliegt. Die zu beschichtende Oberfläche und der Prozesskopf begrenzen dann einen oder mehrere Prozessräume, denen die Prozessgase zugeführt werden. Die Abstandshalter sind beispielsweise so ausgebildet, dass das Substrat von der Mantelfläche des Prozesskopfes beispielsweise einen Abstand zwischen 0,01 und 10 mm, beispielsweise zwischen 0,05 und 5 mm, beispielsweise zwischen 0,1 und 1 mm hat. Der bzw. die Prozessraume haben dann bei angelegtem flexiblen Substrat eine Höhe zwischen 0,01 und 10 mm, bzw. zwischen 0,05 und 5 mm, bzw. zwischen 0,1 und 1 mm. Alternativ oder zusätzlich kann der Abstand zwischen dem Prozesskopf und dem Substrat über einen Überdruck in dem bzw. den Prozessräumen oder über einen Unterdruck auf der von dem bzw. den Prozessräumen abgewandten Seite des Substrats eingestellt werden.

Die Abstandshalter weisen mindestens zwei Stege auf, die bei den axial äußeren Rändern des Prozesskopfes angeordnet sind. Die Stege sind relativ zu dem Prozesskopf drehbar gelagert. Die Stege sind beispielsweise in dem Gehäuse unabhängig von dem Prozesskopf oder an dem Prozesskopf befestigt. Im Betrieb wird das flexible Substrat zumindest teilweise so Uber die Stege und um den Prozesskopf geführt, dass es an seinem nicht zu beschichtenden Rand der zu beschichtenden Oberfläche des Substrats auf den Stegen aufliegt. Die zu beschichtende Oberfläche, der Prozesskopf und die Stege begrenzen dann einen oder mehrere Prozessräume, denen die Prozessgase zugeführt werden. Die Stege können beispielsweise eine Breite zwischen 1 und 20 mm, beispielsweise zwischen 5 und 15 mm haben. Ferner können zwischen den Stegen an den axialen Enden des Prozesskopfes ein, zwei oder mehr weitere Stege angeordnet sein, um zu verhindern, dass das flexible Substrat in Richtung Mantelfläche durchhängt. Die Anzahl und die Breite der Stege kann beispielsweise abhängig von der axialen Länge des Prozesskopfes und/oder der Breite und/oder der Stabilität des flexiblen Substrats gewählt werden. Alternativ oder zusätzlich kann die Mantelfläche so ausgebildet sein, dass das Substrat zwischen den äußeren Stegen durchhängen kann, ohne dass der Abstand zu der Mantelfläche variiert. Beispielsweise kann die Mantelfläche konkav, also nach innen gewölbt, ausgebildet sein. Die radialen Mantelflächen der Stege können beispielsweise durchgehende oder punktuelle Auflageflächen für das Substrat darstellen. Die Gasauslässe sind beispielsweise zwischen den Stegen ausgebildet. Beispielsweise erstrecken sich die Gasauslässe von einem der Stege zu einem anderen der Stege.

Zusätzlich zu den Stegen können Fixierungselemente vorgesehen sein, die dazu dienen, das Substrat während seines Umlaufs um den Prozesskopf in Vorschubrichtung an den Stegen zu fixieren. Beispielsweise können die Stege Stifte und das Substrat zu den Stiften korrespondierende Löcher aufweisen, so dass die Stifte in die Löcher eingreifen und das Substrat relativ zu den drehbar gelagerten Stegen fixiert wird. Alternativ dazu können die Fixierungselemente auch eine oder mehrere Klemmvorrichtungen aufweisen, mit deren Hilfe das Substrat festgeklemmt und/oder in axialer Richtung gespannt werden kann, beispielsweise automatisch.

Gemäß verschiedenen Ausführungsformen weist die Vorrichtung an ihrem radial äußeren Rand mehrere Querwände auf, die in radialer Richtung von dem radial äußeren Rand abstehen und die sich in einer Richtung mit zumindest einer Richtungskomponente in axialer Richtung erstrecken. In anderen Worten ist zumindest eine Richtungskomponente der Erstreckungsrichtung der Querwände parallel zu der Drehachse des Prozesskopfes. In anderen Worten bilden die Querwände Tangenten an die Mantelfläche. Die Querwände teilen den Umfang des Prozesskopfes in mehrere Segmente auf. Die Querwände können optional beispielsweise als Abstandshalter zum Vorgeben eines Abstands zwischen dem radial äußeren Rand, beispielsweise der Mantelfläche, des Prozesskopfes und dem Substrat dienen. Die Querwände können sich beispielsweise von einem der Stege zu einem anderen der Stege erstrecken. Beispielsweise können die Querwände senkrecht zu den Stegen angeordnet sein. Beispielsweise können die Querwände eine geringere Höhe haben als die Abstandshalter, beispielsweise wenn der Abstand zwischen Substrat und dem Mantel des Prozesskopfes mit Hilfe der Abstandshalter und/oder des Überdrucks in dem bzw. den Prozessräumen bzw. des Unterdrucks auf der dem bzw. den Prozessräumen abgewandten Seite des Substrats realisiert wird. Beispielsweise können die Querwände mit den Stegen, mit dem radial äußeren Rand des Prozesskopfes, beispielsweise der Mantelfläche, und mit dem Substrat einzelne Prozessräume bilden, umschließen und/oder voneinander abgrenzen. Dabei kann die Abgrenzung abhängig von der Höhe der Querwände mehr oder weniger diskret sein. Beispielsweise kann vor und/oder nach jeder Querwand ein Gaseinlass zum Absaugen von Prozessgas angeordnet sein. Auf diese Weise können auf dem äußeren Umfang segmentierte Prozessräume gebildet sein, in denen nacheinander unterschiedliche Drücke erzeugt werden können und beispielsweise unterschiedliche Prozessgase zugeführt oder abgesaugt werden können. Beispielsweise kann zwischen je zwei Querwänden je ein Gasauslass zum Zuführen je eines Prozessgases zu dem entsprechenden Prozessraum ausgebildet sein.

Alternativ dazu kann auf die Querwände verzichtet werden, so dass die Abgrenzung der Prozessräume nicht mehr diskret ist, sondern die Prozessräume kontinuierlich ineinander übergehen. Eine Vermischung und/oder Verschleppung der Prozessgase über einzelne Prozessräume hinweg kann über die Partialdrücke der Prozessgase den Prozessräumen eingestellt, insbesondere verringert oder verhindert werden. Zum Verhindern der Verschleppung der Reaktionsgase kann beispielsweise auch das Zuführen des Spülgases zwischen den Reaktionsgasen beitragen. Falls keine Querwände vorgesehen sind oder die Querwände verglichen mit den Abstandshaltern lediglich eine geringe Höhe haben, so gehen die Prozessräume ineinander über und sind im Wesentlichen durch die während des Betriebs in ihnen befindlichen Prozessgase gekennzeichnet. In anderen Worten bilden die Prozessgase Gaspolster, die sich mit dem Prozesskopf mitdrehen und sich mit der Drehgeschwindigkeit des Prozesskopfes über das Substrat hinwegbewegen. Die Gaspolster definieren die Prozessräume. Die Volumina und Formen der Gaspolster und damit der Prozessräume variieren dann abhängig von der Drehgeschwindigkeit des Prozesskopfes, dem Abstand zwischen Prozesskopf und Substrat, den Viskositäten der Prozessgase und/oder den Flussparametern der Prozessgase, beispielsweise abhängig von den Flussdichten, den Differenzdrücken und/oder den Partialdrücken.

Gemäß verschiedenen Ausführungsformen sind in dem Prozesskopf von dem radial äußeren Rand beabstandet Kanäle ausgebildet, die dazu dienen, die Gasauslässe oder die Gaseinlässe am radial äußeren Rand mit Gasdurchführung zu verbinden, über die die Gasauslässe am radial äußeren Rand mit Prozessgas versorgt werden bzw. über die das abgesaugtes Prozessgas abgeführt wird. Die Kanäle können sich in axialer und/oder in radialer Richtung erstrecken. Beispielsweise können sich die Kanäle an den axialen Enden des Prozesskopfes in radialer Richtung erstrecken und/oder von den axialen Enden des Prozesskopfes beabstandet in axialer Richtung erstrecken. Gemäß verschiedenen Ausführungsformen weist die Vorrichtung eine Antriebseinheit zum Drehen des Prozesskopfes auf. Die Antriebseinheit kann beispielsweise einen Motor, ein Getriebe, beispielsweise ein Zahnrad oder eine Übersetzung aufweisen. Die Antriebseinheit kann in das Gehäuse integriert sein oder außerhalb des Gehäuses angeordnet sein und/oder an einer Drehwelle des Prozesskopfes angreifen.

Gemäß verschiedenen Ausführungsformen weist die Vorrichtung mehrere in Reihe angeordnete Prozessköpfe auf. Dass die Prozessköpfe in Reihe angeordnet sind, bedeutet in diesem Zusammenhang, dass das Substrat nacheinander die einzelnen Prozessköpfe durchläuft, wobei die Prozessköpfe so angeordnet sein können, dass von dem bzw. den nachfolgenden Prozessköpfen die gleiche Seite und/oder die andere Seite des Substrats behandelt wird. Dies kann einfach dazu beitragen, nacheinander mehrere gleiche oder unterschiedliche Schichten auf das Substrat aufzubringen.

In verschiedenen Ausführungsformen wird ein Verfahren zur Oberflächenbehandlung eines Substrats bereitgestellt, bei dem das Substrat zumindest teilweise so um den radial äußeren Rand des drehbar gelagerten Prozesskopfes angelegt wird, dass die Oberfläche des flexiblen Substrats dem Prozesskopf zugewandt ist und dass zwischen der Oberfläche des flexiblen Substrats und dem Prozesskopf der Prozessraum gebildet ist. Der Prozesskopf wird gedreht und über den sich drehenden Prozesskopf wird dem Prozessraum zumindest ein Prozessgas zum Behandeln der dem Prozesskopf zugewandten Oberfläche des Substrats zugeführt. Der Prozessraum dreht sich mit dem Prozesskopf.

Gemäß verschiedenen Ausführungsformen ist der Prozesskopf so ausgebildet und das flexible Substrat wird so um den radial äußeren Rand des Prozesskopfes gelegt, dass der zwischen dem radial äußeren Rand des Prozesskopfes und dem Substrat gebildete Prozessraum von dem Prozesskopf und dem flexiblen Substrat begrenzt ist. Beispielsweise kann der Prozessraum durch den radial äußeren Rand, beispielsweise der Mantelfläche, durch je einen Steg an den axialen Enden des äußeren Randes des Prozesskopfes, gegebenenfalls durch zwei der Querwände und durch die zu beschichtende Oberfläche des flexiblen Substrats begrenzt sein. Durch das Zuführen und Abführen des Prozessgases kann in dem Prozessraum beispielsweise ein mittlerer Druck von beispielsweise 0,001 bis 5 bar, beispielsweise von 0,01 bis 2 bar, beispielsweise von 0,1 bis 1,5 bar erzeugt werden. Gemäß verschiedenen Ausführungsformen wird über den radial äußeren Rand des Prozesskopfes ein Prozessgas abgeführt, beispielsweise eines der Reaktionsgase und/oder das Spülgas. Beispielsweise können nacheinander Reaktionsgase abgeführt werden, die sich nicht mischen dürfen, beispielsweise die gasförmigen Edukte bei einem ALD-Prozess. Ferner kann dazwischen das Spülgas abgeführt werden. Dabei kann in dem Prozessraum ein Unterdruck oder ein Differenzdruck beispielsweise zwischen 0,001 und 1 bar, beispielsweise zwischen 0,01 und 0,1 bar, beispielsweise zwischen 0,05 und 0,08 bar erzeugt werden, wobei sich der Differenzdruck beispielsweise auf den Druckunterschied zwischen zwei benachbarten Prozessräumen bezieht.

Gemäß verschiedenen Ausführungsformen wird mit Hilfe des Prozesskopfes ein Beschichtungsverfahren durchgeführt. Das Beschichtungsverfahren kann beispielsweise ein CVD-Prozess oder ein ALD-Prozess sein. Alternativ dazu kann mit Hilfe des Prozesskopfes auch ein Abtragungsprozess durchgeführt werden, beispielsweise ein Trockenätzprozess, beispielsweise kann chemisches Trockenätzen durchgeführt werden. Beispielsweise können monoatomare oder multiatomare Schichten aufgebracht werden, die wenige Angström bis hin zu mehrere Nanometer dick sein können. Beispielsweise können 100 bis 200 gleiche oder unterschiedliche übereinanderliegende Schichten auf das Substrat aufgebracht werden. Die Dicke der jeweiligen Schicht hängt lediglich davon ab, wie viele Umdrehungen der Prozesskopf über dem zu beschichtenden Bereich des Substrats vollzieht, wobei mit zunehmender Anzahl der Umdrehungen die Dicke anwächst.

Gemäß verschiedenen Ausführungsformen wird ein ALD-Prozess durchgeführt.

Gemäß verschiedenen Ausführungsformen werden über den sich drehenden Prozesskopf nacheinander erst ein erstes Reaktionsgas, beispielsweise ein erstes gasförmiges Edukt, dann ein Spülgas und dann ein zweites Reaktionsgas, beispielsweise ein zweites gasförmiges Edukt zugeführt. Die Reaktionsgase bzw. das Spülgas können beispielsweise mehrmals nacheinander wiederholt zugeführt werden, um mehrere Schichtenfolgen zu erzeugen. Darüber hinaus können auch weitere gasförmige Edukte zugeführt werden, um unterschiedliche Schichten zu erzeugen. Mit dem ersten gasförmigen Edukt wird beispielsweise die zu beschichtende Oberfläche des flexiblen Substrats gesättigt und das zweite gasförmige Edukt lagert sich auf der Schicht des ersten gasförmigen Edukts ab. Dadurch entsteht eine monoatomare erste Schicht, insbesondere bei einer Umdrehung des Prozesskopfes. Darüber hinaus können durch Zuführen weiterer Edukte eine, zwei oder mehr weitere Schichten während einer Umdrehung des Prozesskopfes gebildet werden und/oder es können bei nachfolgenden Umdrehungen weitere Schichten aus dem bzw. den gleichen Materialien oder Materialkombinationen oder anderen Materialien oder Materialkombinationen gebildet werden. Dies ermöglicht beispielsweise, alternierend erste ALD-Schichten und zweite ALD-Schichten aufzubringen. Alternativ dazu kann während mehrerer Umdrehungen lediglich ein erstes Reaktionsgas zugeführt werden und nachfolgend bei mehreren weiteren Umdrehungen ein zweites Reaktionsgas zugeführt werden. Ferner können während mehreren Umdrehungen jeweils zwei Reaktionsgase zugeführt werden und während weiteren mehreren Umdrehungen können jeweils zwei weitere Reaktionsgase zugeführt werden. Dies ermöglicht beispielsweise, mehrere Schichten einer ersten ALD-Schicht und dann mehrere Schichten einer zweiten ALD-Schicht aufzubringen.

Gemäß verschiedenen Ausführungsformen wird der Vorschub des Substrats während der Oberflächenbehandlung angehalten oder nicht. Beispielsweise kann der Vorschub des Substrats getaktet sein, so dass nacheinander aufeinanderfolgende längliche Bereiche des Substrats behandelt werden. Während eines Takts können mehrere Schichten gleichen oder unterschiedlichen Materials oder gleicher oder unterschiedlicher Materialkombinationen auf dem Substrat abgeschieden oder von diesem entfernt werden. Alternativ dazu kann der Vorschub des Substrats kontinuierlich erfolgen, beispielsweise mit einer konstanten Vorschubgeschwindigkeit. Auch dabei können mehrere Schichten gleichen oder unterschiedlichen Materials oder gleicher oder unterschiedlicher Materialkombinationen auf dem flexiblen Substrat abgeschieden oder von diesem entfernt werden, beispielsweise wenn eine Umfangsgeschwindigkeit des Prozesskopfes größer ist als eine Vorschubgeschwindigkeit des Substrats.

Gemäß verschiedenen Ausführungsformen ist eine Umfangsgeschwindigkeit des Prozesskopfes größer als eine Vorschubgeschwindigkeit des Substrats. Die Vorschubgeschwindigkeit des Substrats kann beispielsweise bei Verwendung eines Prozesskopfes in einem Bereich zwischen 0 und 100 m/min liegen, beispielsweise zwischen 0,1 und 10 m/min, beispielsweise zwischen 0,5 und 5 m/min. Bei Verwendung von mehreren Prozessköpfen hintereinander, kann die Vorschubgeschwindigkeit mit zunehmender Anzahl von Prozessköpfen weiter erhöht werden. Eine Drehfrequenz des Prozesskopfes kann in einem Bereich zwischen 1 und 1000 U/min liegen, beispielsweise zwischen 100 u. 500 U/min, beispielsweise zwischen 150 und 250 U/min. Die Umfangsgeschwindigkeit, in anderen Worten die Geschwindigkeit, mit der sich ein Punkt am radial äußeren Rand des Prozesskopfes bewegt, hängt von der Drehgeschwindigkeit und dem Radius des Prozesskopfes ab.

Gemäß verschiedenen Ausführungsformen kann das Substrat um den radial äußeren Rand eines weiteren oder weiterer Prozessköpfe angelegt werden und die Oberfläche des Substrats kann mit diesen entsprechend weiter behandelt werden. Beispielsweise kann mit einem ersten Prozesskopf eine erste Seite des Substrats beschichtet werden und mit einem zweiten Prozesskopf kann eine von der ersten Seite abgewandte zweite Seite des Substrats beschichtet werden. Alternativ dazu kann mit zwei oder mehr Prozessköpfen mehrmals die gleiche Seite des Substrats beschichtet werden.

In verschiedenen Ausführungsformen wird ein Verfahren zum Herstellen eines optoelektronischen Bauelements bereitgestellt, das das vorstehend und/oder nachfolgend beschriebene Verfahren zur Oberflächenbehandlung des Substrats aufweist. Beispielsweise wird dabei das Substrat mit einer Elektrodenschicht, einer optisch funktionellen Schicht, einer organisch funktionellen Schicht, einer Barrierenschicht und/oder einer Verkapselungsschicht beschichtet. Beispielsweise kann das Substrat eine Folie sein. Beispielsweise kann die Verkapselungsschicht für Wasserdampf und/oder Gase weitgehend undurchlässig sein. Ferner kann die optisch funktionelle Schicht beispielsweise (hoch) Brechungsschicht, beispielsweise eine hoch brechende Schicht, eine Streuschicht oder eine Konverterschicht zum Konvertieren von Licht sein. Ferner können auf dem Substrat bereits Strukturen gebildet sein, die beschichtet werden. Beispielsweise kann auf dem Substrat bereits ein Stapel (Stack) von Schichten und/oder beispielsweise ein Schichtpaket ausgebildet sein.

Ausführungsformen der Erfindung sind in den Figuren dargestellt und werden im Folgenden näher erläutert.

Es zeigen:
- **Fig. 1**: eine schematische Ansicht eines Ausführungsbeispiels einer Vorrichtung zur Oberflächenbehandlung eines Substrats;
- **Fig. 2**: eine Schnittansicht durch ein Ausführungsbeispiel einer Vorrichtung zur Oberflächenbehandlung eines Substrats senkrecht zu einer Drehachse eines Prozesskopfes der Vorrichtung;
- **Fig. 3**: eine perspektivische Ansicht des Ausführungsbeispiels der Vorrichtung zur Oberflächenbehandlung eines Substrats gemäß Figur 2;
- **Fig. 4**: ein Schnitt durch das Ausführungsbeispiel der Vorrichtung zur Oberflächenbehandlung eines Substrats gemäß Figur 2 entlang der Drehachse des Prozesskopfes der Vorrichtung;
- **Fig. 5**: eine Seitenansicht einer Gasführung der Vorrichtung gemäß Figur 2;
- **Fig. 6**: ein Schnitt durch die Gasführung gemäß Figur 5;
- **Fig. 7**: eine schematische Seitenansicht eines beispielhaften Prozesskopfes einer Vorrichtung zur Oberflächenbehandlung eines Substrats;
- **Fig. 8**: eine erste beispielhafte Schichtstruktur;
- **Fig. 9**: eine zweite beispielhafte Schichtstruktur;
- **Fig. 10**: eine dritte beispielhafte Schichtstruktur;
- **Fig. 11**: ein Ablaufdiagramm eines Ausführungsbeispiels eines Verfahrens zur Oberflächenbehandlung eines Substrats;
- **Fig. 12**: ein Ablaufdiagramm eines weiteren Ausführungsbeispiels eines Verfahrens zur Oberflächenbehandlung eines Substrats;
- **Fig. 13**: ein Ausführungsbeispiel einer Vorrichtung zur Oberflächenbehandlung eines Substrats;
- **Fig. 14**: ein weiteres Ausführungsbeispiel einer Vorrichtung zur Oberflächenbehandlung eines Substrats;
- **Fig. 15**: ein Ausführungsbeispiel eines Prozesskopfes in Seitenansicht;
- **Fig. 16**: ein weiteres Ausführungsbeispiel eines Prozesskopfes in Seitenansicht;
- **Fig. 17**: ein Diagramm zum Veranschaulichen eines Funktionsprinzips einer Vorrichtung zur Oberflächenbehandlung eines Substrats und einer Verschleppung von Prozessgasen.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Ein opto-elektronisches Bauelement kann ein Licht emittierendes Bauelement oder ein Licht absorbierendes Bauelement sein. Unter einem Licht emittierenden Bauelement kann in verschiedenen Ausführungsbeispielen eine organische Licht emittierende Diode (organic light emitting diode, OLED), eine Licht emittierende elektrochemische Zelle (light emitting electrochemical cell, LEC) oder ein organischer Licht emittierender Transistor verstanden werden. Das Licht emittierende Bauelement kann gemäß verschiedenen Ausführungsbeispielen Teil einer integrierten Schaltung sein.

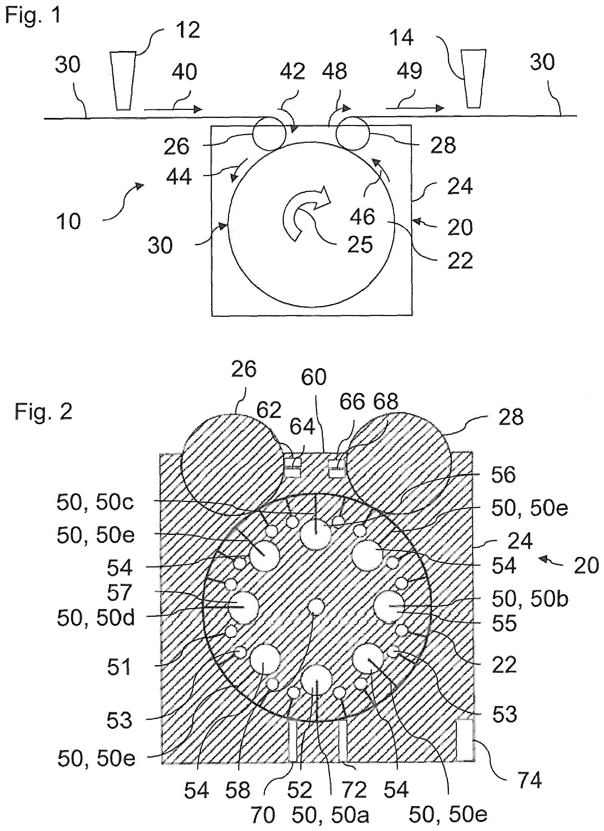

**Fig.1** zeigt eine schematische Ansicht eines Ausführungsbeispiels einer Vorrichtung 10 zur Oberflächenbehandlung eines Substrats 30. Die Vorrichtung 10 kann optional eine erste Prozessstufe 12 und/oder eine zweite Prozessstufe 14 aufweisen. Die Vorrichtung 10 weist weiter eine Prozesseinheit 20 auf, die einen Prozesskopf 22 aufweist, der in einem Gehäuse 24 in einer Rotationsrichtung 25 drehbar gelagert ist. Das Gehäuse 24 ermöglicht beispielsweise, eine Umgebung der Prozesseinheit 20 vor Prozessgasen zu schützen, Prozessbereiche in dem Gehäuse 24 zu temperieren und/oder das Substrat 30 zu schützen.

Das Substrat 30 weist beispielsweise eine Kapton-Folie (PI), eine Metallfolie oder eine PET-Folie auf. Beispielsweise kann das Substrat 30 eine Stahlfolie, eine Kunststofffolie oder ein Laminat mit einer oder mit mehreren Kunststofffolien aufweisen oder daraus gebildet sein. Der Kunststoff kann ein oder mehrere Polyolefine (beispielsweise Polyethylen (PE) mit hoher oder niedriger Dichte oder Polypropylen (PP)) aufweisen oder daraus gebildet sein. Ferner kann der Kunststoff Polyvinylchlorid (PVC), Polystyrol (PS), Polyester und/oder Polycarbonat (PC), Polyethylenterephthalat (PET), Polyethersulfon (PES), PEEK, PTFE und/oder Polyethylennaphthalat (PEN) aufweisen oder daraus gebildet sein. Das Substrat 30 kann eines oder mehrere der oben genannten Materialien aufweisen.

Die Vorrichtung 10 weist weiter eine Vorschubvorrichtung auf, die beispielsweise eine erste Walze 26 und eine zweite Walze 28 aufweist. Die Drehachsen der Walzen 26, 28 können beispielsweise parallel zu der Drehachse 58 des Prozesskopfes 22 ausgebildet sein.

Die Prozesseinheit 20, der Prozesskopf 22 und die Vorschubvorrichtung können beispielsweise so ausgebildet sein, dass das Substrat 30, welches beispielsweise ein flexibles Substrat ist, der Prozesseinheit 20 zugeführt werden kann, um den Prozesskopf 22 geführt werden kann und über die zweite Walze 28 aus der Prozesseinheit 20 heraus geführt werden kann. Bei dem Vorschubprozess bewegt sich das Substrat 30 entlang einer ersten Richtung 40 hin zu der ersten Walze 26 und legt sich entlang einer zweiten Richtung 42 um die erste Walze 26, so dass es mit einem radial äußeren Rand des Prozesskopfes 22 in Kontakt kommt. Das Substrat legt sich entlang einer dritten Richtung 44 und einer vierten Richtung 46 um den Prozesskopf 22 bis zu der zweiten Walze 28. An der zweiten Walze 28 biegt sich das Substrat 30 in eine fünfte Richtung 48, wird dadurch aus der Prozesseinheit 20 heraus geführt und verläuft weiter entlang einer sechsten Richtung 49.

Das Substrat 30 kann so am radial äußeren Rand des Prozesskopfes 22 und, im Falle des flexiblen Substrats, zumindest teilweise um den radial äußeren Rand des Prozesskopfes 22 herum angeordnet werden. Dadurch kann die dem Prozesskopf 22 zugewandte Oberfläche des Substrats 30 mit Hilfe des Prozesskopfes 22 behandelt werden. Dies ermöglicht, das Substrat 30 in einem Substratverband, beispielsweise als Endlos-Substrat, beispielsweise als Endlos-Folie, nach und nach an dem radial äußeren Rand des Prozesskopfes 22 vorbei zu schieben und dabei das Endlos-Substrat zu behandeln. Dies ermöglicht, die Behandlung der Oberfläche des Substrats 30 in einem Roll-to-Roll Prozess durchzuführen, ohne das Substrat 30 vereinzeln zu müssen. Beispielsweise kann das flexible Substrat 30 in dem Roll-to-Roll Prozess beschichtet werden, beispielsweise in einem CVD-Prozess, beispielsweise in einem ALD-Prozess.

Die Vorrichtung 10 und insbesondere die Prozesseinheit 20 dienen dazu, eine Oberfläche des Substrats 30 zu behandeln, beispielsweise zu beschichten. Alternativ dazu kann eine Oberflächenschicht auf dem Substrat 30 mit Hilfe der Prozesseinheit 20 abgetragen werden. Das Substrat 30 kann beispielsweise auf einer in Figur 1 linken Seite der Vorrichtung 10 von einer nicht dargestellten Rolle abgerollt werden, seine Oberfläche kann mit Hilfe der Prozesseinheit 20 behandelt werden und das behandelte Substrat 30 kann auf einer in Figur 1 rechten Seite der Vorrichtung 10 auf eine nicht dargestellte weitere Rolle aufgerollt werden. Danach kann das Substrat 30 wieder abgerollt und vereinzelt werden. Alternativ dazu kann das Substrat 30 direkt nach der Oberflächenbehandlung vereinzelt werden. Das noch nicht vereinzelte Substrat 30 kann auch als Substratverband bezeichnet werden. Das Substrat 30 kann bereits beschichtet sein, beispielsweise mit einer organisch funktionellen Schichtenstruktur zum Emittieren oder Absorbieren von Licht und/oder mit einer oder mehreren Elektrodenschichten. Beispielsweise kann das Substrat 30 optional mit Hilfe der optional angeordneten ersten Prozessstufe 12 und/oder der zweiten Prozessstufe 14 beschichtet werden.

**Fig. 2** zeigt eine vergrößerte Schnittansicht der in Figur 1 gezeigten Ausführungsbeispiele der Prozesseinheit 20 mit dem Prozesskopf 22. Der Prozesskopf 22 ist um eine Drehachse 58 drehbar gelagert. Der Prozesskopf 22 ist zylinderförmig ausgebildet und weist eine Achse und eine Mantelfläche auf, die an dem radial äußeren Rand des Prozesskopfes 22 ausgebildet ist, wobei die Achse auf der Drehachse 58 liegt. Beispielsweise kann der Prozesskopf im Wesentlichen einen geraden Zylinder bilden, dessen Achse von einem Mittelpunkt seiner Deckfläche zum Mittelpunkt seiner Grundfläche verläuft. In anderen Worten kann der Prozesskopf 22 trommelförmig ausgebildet sein. Der Prozesskopf 22 weist mehrere Gaseinlässe 51 und mehrere Gasauslässe 50 auf, die an dem radial äußeren Rand, beispielsweise an der Mantelfläche, des Prozesskopfes 22 ausgebildet sind. Die Gasauslässe 50 sind so ausgebildet und angeordnet, dass im Betrieb ein Prozessgas zumindest einen der Gasauslässe 50 in einer Richtung mit einer radial gerichteten Richtungskomponente verlässt. In axialer Richtung kann der Prozesskopf 22 beispielsweise abhängig von der Breite des zu behandelnden Substrats 30 beispielsweise zwischen 1 mm und 10000 mm, beispielsweise zwischen 10 mm u. 1000 mm, beispielsweise zwischen 100 mm u. 500 mm breit sein. Der Radius des Prozesskopfes 22 kann beispielsweise zwischen 10 mm und 1000 mm, beispielsweise zwischen 100 mm und 600 mm sein.

Die Gasauslässe 50 an dem radial äußeren Rand ermöglichen eine Oberflächenbehandlung des Substrats 30 bei einem geringen Gasverbrauch und einer hohen Prozessgeschwindigkeit, insbesondere wenn pro Schicht mehrere Reaktionsgase nacheinander benötigt werden und/oder wenn mehrere gleiche oder unterschiedliche Schichten übereinander auf- oder abgetragen werden müssen. Des Weiteren kann die Prozesseinheit 20 sehr kompakt ausgebildet werden und ist daher einfach in eine bestehende Produktionslinie einfügbar. In verschiedenen Ausführungsbeispielen kann ein Prozessgas beispielsweise in radialer Richtung, also senkrecht zur Drehachse 58 aus dem Prozesskopf 22 geblasen werden. Alternativ dazu kann das Prozessgas nur teilweise in radialer Richtung gerichtet aus dem Prozesskopf 22 geblasen werden, beispielsweise unter Berücksichtigung einer Strömungsoptimierung bei sich drehendem Prozesskopf 22.

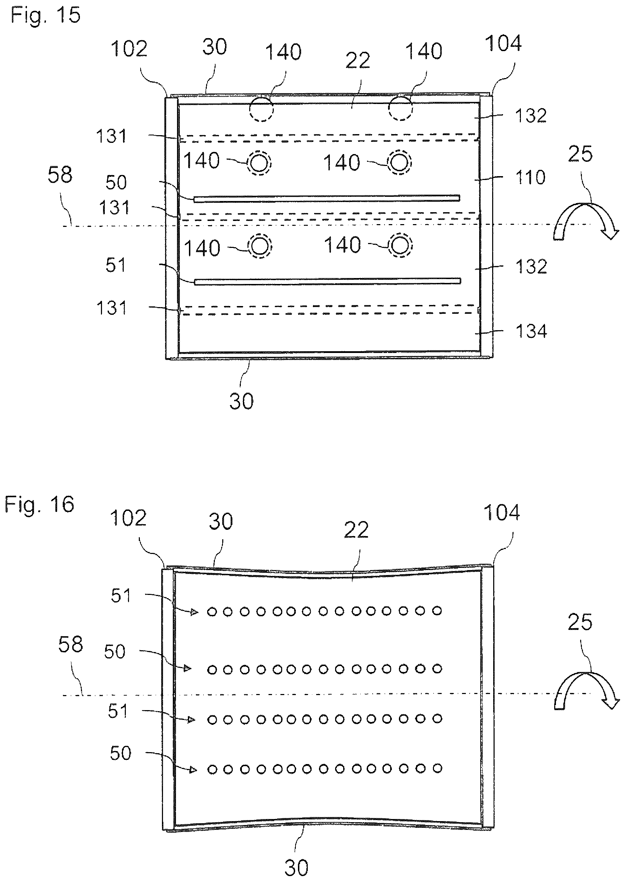

Die Gasauslässe 50 und/oder die Gaseinlässe 51 an der Mantelfläche können schlitzförmig ausgebildet sein. Beispielsweise können die Gasauslässe 50 durch je einen Schlitz (siehe Figur 15) ausgebildet sein, der sich in axialer Richtung quer über die Mantelfläche erstreckt, beispielsweise parallel zu der Drehachse 58 und/oder von einem axialen Ende des Prozesskopfes 22 zu dem anderen axialen Ende des Prozesskopfes 22, und der sich in radialer Richtung von dem äußeren Umfang des Prozesskopfes 22 hinein in den Prozesskopf 22 hin zu mehreren von dem radial äußeren Rand des Prozesskopfes 22 beabstandeten Kanälen 52, 54, 55, 56, 57 erstreckt, die dazu dienen, die Gasauslässe 50 zum Zuführen oder die Gasauslässe 51 zum Abführen der Prozessgase mit weiter unter beschriebenen Gasdurchführungen zu verbinden. Die schlitzförmige Ausbildung der Gasauslässe 50 trägt dazu bei, dass das um den äußeren Rand angeordnete Substrat 30 gleichmäßig beschichtet wird. Alternativ dazu können die Gasauslässe 50 kreisförmig oder eckig ausgebildet sein (siehe Figur 16). Alternativ dazu können ein, zwei oder mehr schlitzförmige oder kreisförmige Auslässe gemeinsam einen der Gasauslässe 50 bilden.

Beispielsweise kann der Prozesskopf 22 mehrere Gasauslässe 50 aufweisen, die zum Zuführen eines ersten Reaktionsgases einen ersten Gasauslass 50a aufweisen, der mit einem ersten Kanal 52 kommuniziert, und/oder zum Zuführen eines zweiten Reaktionsgases einen zweiten Gasauslass 50b aufweisen, der mit einem zweiten Kanal 55 kommuniziert. Ferner kann der Prozesskopf 22 zum Zuführen des ersten Reaktionsgases oder zum Zuführen eines dritten Reaktionsgases einen dritten Gasauslass 50c aufweisen, der mit einem dritten Kanal 56 kommuniziert, und/oder zum Zuführen des zweiten Reaktionsgases oder eines vierten Reaktionsgases einen vierten Gasauslass 50d aufweisen, der mit einem vierten Kanal 57 kommuniziert, und/oder zum Zuführen eines Spülgases als weiteres oder fünftes Prozessgas einen oder mehrere weitere bzw. fünfte Gasauslässe 50e aufweisen, der bzw. die mit einem bzw. mehren fünften Kanälen 54 kommunizieren.

Die Gasauslässe 50a, 50b, 50c, 50d, 50e ermöglichen, beispielsweise drei unterschiedliche Prozessgase zuzuführen, beispielsweise in einem ALD-Prozess als erstes Prozessgas ein erstes gasförmiges Edukt und als zweites Prozessgas ein zweites gasförmiges Edukt zum Erzeugen einer Materialschicht eines ersten Materials oder einer ersten Materialkombination und als weiteres Prozessgas ein Spülgas zum Durchführen einer Spülung (Purge). Bei dem ALD-Prozess werden das erste und zweite gasförmige Edukt auch als erster bzw. zweiter Precursor bezeichnet. Zusätzlich können zwei weitere Prozessgase zugeführt werden, beispielsweise als drittes Prozessgas ein dritter Precursor und als viertes Prozessgas ein vierter Precursor zum Erzeugen einer Materialschicht eines zweiten Materials oder einer zweiten Materialkombination. Darüber hinaus können noch weitere Gasauslässe vorgesehen sein, beispielsweise können zwei weitere Edukte zugeführt werden oder es können auch mehrere Gasauslässe für eines der Prozessgase vorgesehen sein.

Zwischen den Gasauslässen 50 am äußeren Rand des Prozesskopfes 22 können je ein oder zwei der Gaseinlässe 51 am äußeren Rand des Prozesskopfes 22 ausgebildet sein. Die Gaseinlässe 51 können den Gasauslässen 50 entsprechend schlitzförmig und/oder kreisförmig ausgebildet sein und sich in axialer Richtung quer über die Mantelfläche erstrecken, beispielsweise parallel zu der Drehachse 58 und/oder von einem axialen Ende des Prozesskopfes 22 zu dem anderen axialen Ende des Prozesskopfes 22, und sich in radialer Richtung von dem äußeren Umfang des Prozesskopfes 22 hinein in den Prozesskopf 22 hin zu mehreren von dem radial äußeren Rand des Prozesskopfes 22 beabstandeten entsprechenden Kanälen 53 erstrecken, die dazu dienen, die Gaseinlässe 51 am äußeren Rand des Prozesskopfes 22 mit weiter unten beschriebenen Gasdurchführungen zu verbinden.

In verschiedenen Ausführungsbeispielen kann beispielsweise immer zwischen zwei Gasauslässen 50a, 50b, 50c, 50d für die Edukte je ein fünfter Gasauslass 50e für das Spülgas vorgesehen sein. Ferner kann zwischen den Gasauslässen 50a, 50b, 50c, 50d der Edukte jeweils ein Gaseinlass 51 zum Absaugen der Edukte bzw. des Spülgases vorgesehen sein. So können beispielsweise entlang des Umfangs des radial äußeren Rands nacheinander ein erster Gasauslass 50a für das erste Edukt, ein Gaseinlass 51 zum Absaugen des ersten Edukts, ein fünfter Gasauslass 50e für das Spülgas 50e, ein weiterer Gaseinlass 51 zum Absaugen des Spülgases, ein zweiter Gasauslass 50b für das zweite Edukt, ein weiterer Gaseinlass 51 zum Absaugen des zweiten Edukts, ein weiterer fünfter Gasauslass 50e für das Spülgas und ein weiterer Gaseinlass 51 zum Absaugen des Spülgases vorgesehen sein. Diese Reihenfolge kann mehrmals wiederholt werden, und/oder es können noch weitere Gasauslässe 50 für weitere Edukte vorgesehen sein.

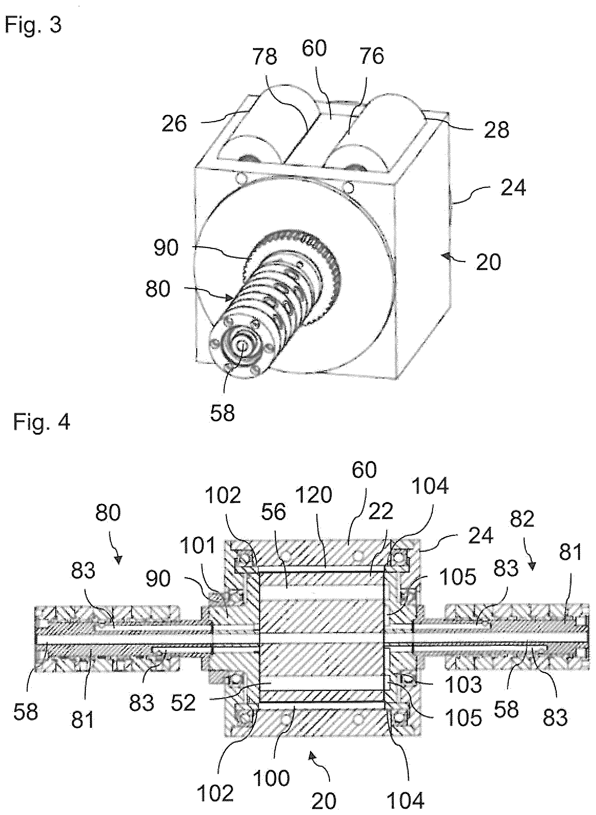

Die Kanäle 52, 53, 54, 55, 56, 57 können sich in axialer und/oder radialer Richtung durch den Prozesskopf 22 erstrecken. Beispielsweise können sich die Kanäle 52, 53, 54, 55, 56, 57 an den axialen Enden des Prozesskopfes 22, in anderen Worten an der Grundfläche und/oder der Deckfläche der Zylinderform, in radialer Richtung erstrecken und von den axialen Enden des Prozesskopfes 22 beabstandet in axialer Richtung erstrecken. Alternativ zu den sich radial erstreckenden Teilen der Kanäle 52, 53, 54, 55, 56, 57 können Stirnkörper 101, 103 (siehe Fig. 4) angeordnet werden, die mit dem Prozesskopf 22 gekoppelt sind und die die radialen Teile der Kanäle 52, 53, 54, 55, 56, 57 aufnehmen und so die sich axial erstreckenden Kanäle 52, 53, 54, 55, 56, 57 mit den weiter unten erläuterten Gasdurchführungen verbinden.

Im Bereich der Vorschubvorrichtung mit der ersten Walze 26 und der zweiten Walze 28, beispielsweise zwischen der ersten Walze 26 und der zweiten Walze 28, können ein Zwischenstück 60, eine erste Gehäuse-Absaugung 62 zum Absaugen von Prozessgas aus dem Gehäuse 24, eine erste Gehäuse-Spülgaszuführung 64 zum Zuführen von Spülgas in das Gehäuse 24, eine zweite Gehäuse-Absaugung 66 zum Absaugen von Gas aus dem Gehäuse 24 und/oder eine zweite Gehäuse-Spülgaszuführung 68 zum Zuführen von Spülgas in das Gehäuse 24 ausgebildet sein, welche beispielsweise der zu behandelnden Oberfläche des Substrats 30 zugewandt sind. Zusätzlich können noch weitere Absaugungen 62, 66 angeordnet sein. Die weiteren Absaugungen 62, 66 können beispielsweise nacheinander von außen nach innen oder von innen nach außen beispielsweise sequentiell nach außen angeordnet sein, so dass nach dem Prinzip des differentiellen Pumpens das Eindringen von Umgebungsluft in das Gehäuse 24 und/oder das Austreten von Prozessgasen aus dem Gehäuse 24 verhindert wird. Ferner kann in dem Gehäuse 24 eine Absaugung so angeordnet sein, dass das Substrat 30 in dem Gehäuse 24 von dem Prozesskopf 22 weggesaugt wird, wodurch ein Abstand zwischen der Mantelfläche des Prozesskopfes 22 und dem Substrat 30 vorgegeben wird.

Alternativ oder zusätzlich können eine dritte Gehäuse-Spülgaszuführung 70 zum Zuführen von Spülgas in das Gehäuse 24 und/oder eine dritte Gehäuse-Absaugung 72 zum Absaugen von Gas aus dem Gehäuse 24 ausgebildet sein, die beispielsweise von der Vorschubvorrichtung beabstandet sind und/oder die beispielsweise auf einer von der zu behandelnden Oberfläche des Substrats 30 abgewandten Seite des Substrats 30 angeordnet sein können. Beispielsweise kann die dritte Gehäuse-Absaugung 72 dazu beitragen, das Substrat 30 von dem Prozesskopf 22 wegzusaugen und/oder den Abstand zwischen dem Substrat 30 und der Mantelfläche des Prozesskopfes 22 vorzugeben.

Das Spülgas kann so beispielsweise auf der zu beschichtenden Oberfläche des Substrats 30, beispielsweise im Bereich der Vorschubvorrichtung, beispielsweise zwischen den Walzen 26, 28, und/oder auf der nicht zu beschichtenden Oberfläche des Substrats 30 zugeführt werden, beispielsweise von der Vorschubvorrichtung beabstandet.

In dem Gehäuse 24 kann eine Heizvorrichtung 74 angeordnet sein, mit der ein Innenraum des Gehäuses 24 beheizt werden kann. Alternativ oder zusätzlich kann das Gehäuse 24 mit Hilfe von erwärmtem Spülgas beheizt werden. Alternativ oder zusätzlich kann der Prozesskopf 22 beheizt werden. Eine Temperatur in dem Gehäuse 14 kann zwischen 0° und 1000° C liegen, beispielsweise zwischen 20° und 500° C, beispielsweise zwischen 150° und 250°, beispielsweise bei ungefähr 200° C.

**Fig. 3** zeigt, dass das Gehäuse 24 eine Zuführöffnung 78 zum Zuführen des Substrats 30 und eine Abfuhröffnung 76 zum Abführen des Substrats 30 aufweisen kann. Ferner kann die Prozesseinheit 20 eine Antriebseinheit 90 zum Drehen des Prozesskopfes 22 aufweisen. Die Antriebseinheit 90 kann beispielsweise einen Motor, ein Getriebe, beispielsweise ein Zahnrad oder eine Übersetzung aufweisen. Die Antriebseinheit kann in das Gehäuse 24 integriert sein, oder außerhalb des Gehäuses 24 an eine Drehwelle, die auf der Drehachse 58 liegt, des Prozesskopfes 22 angreifen.

Zum Zuführen und Abführen der Prozessgase zu dem bzw. von dem Prozesskopf 22 können beispielsweise eine oder zwei Drehdurchführungen 80, 82 (siehe Figur 4) vorgesehen sein.

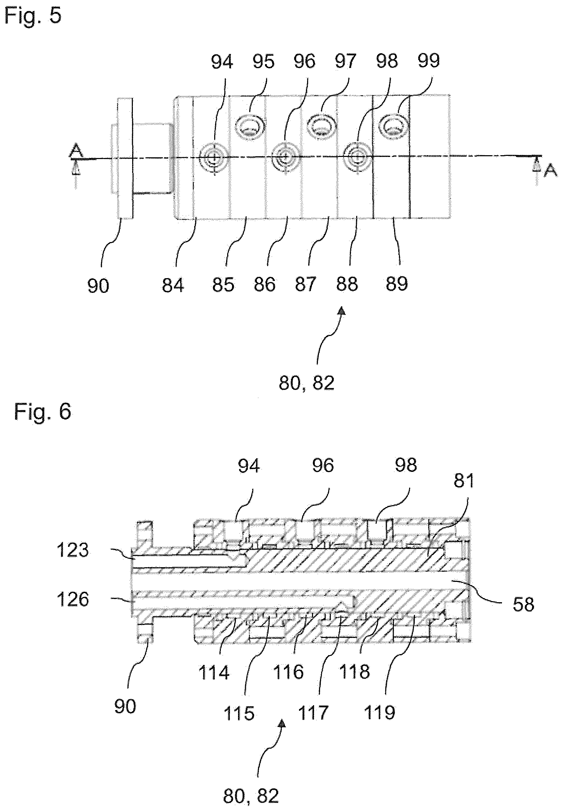

**Fig. 4** zeigt einen Schnitt durch die Prozesseinheit 20 und durch eine erste Drehdurchführung 80 und eine zweite Drehdurchführung 82. Die Drehdurchführungen 80, 82 weisen je einen drehbaren Innenkörper 81 auf, die um die Drehachse 58 drehbar sind. Beispielsweise können die Innenkörper 81 an derselben Drehwelle befestigt sein wie der Prozesskopf 22 oder die Drehdurchführungen 80, 82 können eigene Drehwellen aufweisen, die mechanisch mit der Drehwelle des Prozesskopfes 22 gekoppelt sind. Der Innenkörper 81 weist mehrere sich axial erstreckende Hohlräume 83 auf, die zum Zuführen oder zum Abführen von Prozessgasen ausgebildet sind, die auch als Gasdurchführungen bezeichnet werden können und die weiter unten mit Bezug zu Figur 6 naher erläutert werden.

Figur 4 zeigt weiter, dass sich die Kanäle 52, 53, 54, 55, 56, 57, beispielsweise die Kanäle 52, 56, in axialer Richtung durch den Prozesskopf 22 erstrecken und dass der Prozesskopf 22 in axialer Richtung mit einem ersten Stirnkörper 101 und mit einem zweiten Stirnkörper 103 mechanisch gekoppelt ist, wobei die beiden Stirnkörper 101, 103 den Prozesskopf 22 mit der ersten bzw. zweiten Drehdurchführung 80, 82 mechanisch koppeln. Die Stirnkörper 101, 103 können beispielsweise Ausnehmungen 105 aufweisen, die sich zumindest teilweise in radialer Richtung erstrecken und über die die Hohlräume 83 der Drehdurchführungen 80, 82, also über die Gasdurchführungen, mit den Kanälen 52 53, 54, 55, 56, 57 kommunizieren können. In anderen Worten bilden die Ausnehmungen 105 radiale Teile der Kanale 52, 53, 54, 55, 56, 57. Alternativ oder zusätzlich können beispielsweise nicht dargestellte Ausnehmungen an oder bei Stirnflächen des Prozesskopfes 22, in anderen Worten an der Grundfläche und/oder der Deckfläche der Zylinderform des Prozesskopfes 22, ausgebildet sein, die die radialen Teile der Kanale 52, 53, 54, 55, 56, 57 bilden und über die die Hohlräume 83 der Drehdurchführungen 80, 82 mit den Kanälen 52, 53, 54, 55, 56, 57 kommunizieren können.

Zum Anordnen des Substrats 30 um den Prozesskopf 22 herum weist die Vorrichtung 10 benachbart zu den axial äußeren Enden des radial äußeren Rands des Prozesskopfs 22 je einen Steg 102, 104 auf, der jeweils von dem Mantel des Prozesskopfs 22 in radialer Richtung absteht und der beispielsweise um den ganzen Umfang oder um Abschnitte des Umfangs des Prozesskopfes 22 herum verläuft. Die Stege 102, 104 dienen als Abstandshalter zum Vorgeben des Abstands zwischen der Mantelfläche des Prozesskopfes 22 und dem Substrat 30. Zusätzlich zu den Stegen 102, 104 können weitere Abstandshalter 140 vorgesehen sein (siehe Figur 15). Im Betrieb der Prozesseinheit 20 kann das Substrat 30 zumindest teilweise so um den Prozesskopf 30 geführt werden, dass es an seinen nicht zu beschichtenden Seitenrändern der zu beschichtenden Oberfläche auf den Stegen 102, 104 aufliegt. Die zu beschichtende Oberfläche des Substrats 30, die Mantelfläche des Prozesskopfes 22 und die Stege 102, 104 begrenzen dann einen oder mehrere Prozessräume, beispielsweise einen ersten Prozessraum 100 und einen dritten Prozessraum 120, denen im Betrieb die Prozessgase zum Behandeln der Oberfläche des Substrats 20 zugeführt werden. Die Stege 102, 104 stehen beispielsweise zwischen 0,01 und 10 mm, beispielsweise zwischen 0,05 und 5 mm, beispielsweise zwischen 0,1 und 1 mm vom radial äußeren Rand des Prozesskopfes 22 in radialer Richtung ab, so dass die Prozessraume bei angelegtem Substrat 30 eine Höhe zwischen 0,01 und 10 mm, beispielsweise zwischen 0,05 und 5 mm, beispielsweise zwischen 0,1 und 1 mm hat. Die Stege 102, 104 können beispielsweise eine Breite zwischen 1 und 20 mm, beispielsweise zwischen 5 und 15 mm haben. Die Gasauslässe 50 und Gaseinlässe 51 sind beispielsweise zwischen den Stegen 102, 104 ausgebildet. Die Prozessraume 100, 120 sind durch das Volumen definiert und/oder gekennzeichnet, in dem sich ein bestimmtes Prozessgas befindet und/oder dem ein vorgegebenes Prozessgas zugeführt werden soll oder in dem ein oder zwei Prozessgase abgeführt werden sollen. Die Prozessraume 100, 120 rotieren mit dem Prozesskopf 22 und sich über die zu beschichtende Substratoberfläche bewegt.

Zusätzlich können zwischen den Stegen 102, 104 ein, zwei oder mehr weitere entsprechende Stege angeordnet sein, auf die das Substrat 30 zusätzlich aufgelegt werden kann, beispielsweise um zu verhindern, dass das Substrat 30 durchhängt, wodurch sich die Prozessräume verkleinern würden. Das Anordnen der weiteren Stege kann beispielsweise abhängig von der axialen Länge des Prozesskopfes 22, der Breite und/oder der Stabilität des zu behandelnden Substrats 30 erfolgen.

Ferner können zusätzlich zu den Stegen 102, 104 nicht dargestellte Fixierungselemente vorgesehen sein, die dazu dienen, das Substrat 30 während seines Umlaufs um den Prozesskopf 22 in der dritten und vierten Richtung 44, 46 an den Stegen 102, 104 zu Fixieren. Beispielsweise können die Stege 102, 104 Stifte und das Substrat 30 zu den Stiften korrespondierende Löcher aufweisen, so dass die Stifte in die Löcher eingreifen und das Substrat 30 während des Vorschubs relativ zu den drehbar gelagerten Stegen 102, 104 fixiert wird und mit den Stegen 102, 104 mitgedreht wird oder diese mitdreht, wie es von mit Löcher aufweisendem Endlospapier bestückten Druckern bekannt ist. Alternativ dazu können die Fixierungselemente auch eine oder mehrere Klemmvorrichtungen aufweisen, mit deren Hilfe das Substrat 30 festgeklemmt und/oder in axialer Richtung gespannt ist, beispielsweise automatisch festgeklemmt, werden kann.

**Fig. 5** zeigt ein Beispiel für eine der Drehdurchführungen 80, 82 von außen in Seitenansicht. Die dargestellte Drehdurchführung 80, 82 ist in axialer Richtung in mehrere Segmente unterteilt, beispielsweise in ein erstes Segment 84, ein zweites Segment 85, ein drittes Segment 86, ein viertes Segment 87, ein fünftes Segment 88 und/oder ein sechstes Segment 89. Die Segmente 84 bis 89 können mehrere Anschlussöffnungen aufweisen. Die Segmente 84 bis 89 können aus einem Einzelstück oder aus mehreren mechanisch gekoppelten Einzelstücken bestehen. Beispielsweise kann eine erste Anschlussöffnung 94 an dem ersten Segment 84, eine zweite Anschlussöffnung 95 an dem zweiten Segment 85, eine dritte Anschlussöffnung 96 an dem dritten Segment 86, eine vierte Anschlussöffnung 97 an dem vierten Segment 87, eine fünfte Anschlussöffnung 98 an dem fünften Segment 88 und/oder eine sechste Anschlussöffnung 99 an dem sechsten Segment 89 ausgebildet sein.

Der Innenkörper 81 kann relativ zu den Segmenten 84 bis 89 gedreht werden, so dass die Segmente 84 bis 89 während des Betriebs der Prozesseinheit 20 und somit während einer Rotation des Prozesskopfes 22 und des Innenkörpers 81 ortsfest verbleiben können. Dies ermöglicht, die Anschlussöffnungen 94 bis 99 zum Zuführen oder Abführen der Prozessgase mit nicht dargestellten ortsfesten Gasleitungen zu verbinden, über die die Prozessgase dem Prozesskopf 22 zugeführt oder von diesem abgeführt werden können.

**Fig. 6** zeigt einen Schnitt durch die dargestellte Drehdurchführung 80, 82 gemäß Figur 5 entlang der dort gezeigten Schnittkante A-A. Die Segmente 84 bis 89 weisen mehrere Innennuten auf, über die die Anschlussöffnungen 94 bis 99 mit den Hohlräumen 83 (siehe Figur 4) kommunizieren, wobei die Hohlräume 83 beispielsweise eine erste Gasdurchführung 123 und/oder eine vierte Gasdurchführung 126 aufweisen. Beispielsweise weist das erste Segment 84 eine erste Innennut 114 auf, über die die erste Anschlussöffnung 94 mit der ersten Gasdurchführung 123 kommuniziert, das zweite Segment 85 weist eine zweite Innennut 115 auf, über die die zweite Anschlussöffnung 95 mit einer nicht dargestellten zweiten Gasdurchführung kommuniziert, das dritte Segment 86 weist eine dritte Innennut 116 auf, über die die dritte Anschlussöffnung 96 mit einer nicht dargestellten dritten Gasdurchführung kommuniziert, das vierte Segment 87 weist eine vierte Innennut 117 auf, über die die vierte Anschlussöffnung 97 mit der vierten Gasdurchführung 126 kommuniziert, das fünfte Segment 88 weist eine fünfte Innennut 118 auf, über die die fünfte Anschlussöffnung 98 mit einer nicht dargestellten fünften Gasdurchführung kommuniziert, und/oder das sechste Segment 89 weist eine sechste Innennut 119 auf, über die die sechste Anschlussöffnung 99 mit einer nicht dargestellten sechsten Gasdurchführung kommuniziert.

Die Innennuten 114 bis 119 bewirken, dass dem Prozesskopf 22 selbst bei sich drehendem Innenkörper 81 permanent Prozessgase über die Anschlussöffnungen 94 bis 99 und die Gasdurchführungen 123, 126 zugeführt werden können oder von dem Prozesskopf 22 abgeführt werden können.

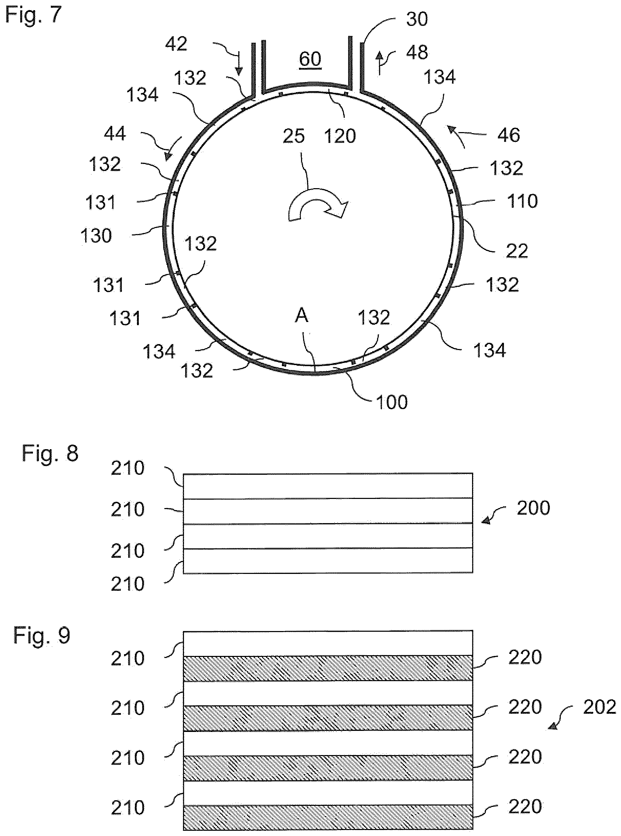

**Fig. 7** zeigt eine schematische Seitenansicht des Prozesskopfes 22, wobei zur besseren Erläuterung die Stege 102, 104 nicht dargestellt sind und das Substrat 30 um den Prozesskopf 22 geführt ist. An dem radial äußeren Rand des Prozesskopfes 22, beispielsweise an seiner Mantelfläche, können beispielsweise mehrere Querwände 131 ausgebildet sein, die den Umfang des Prozesskopfes 22 in mehrere Segmente teilen. Die Querwände 131 können in radialer Richtung von der Mantelfläche abstehen und sich in einer Richtung mit einer Richtungskomponente in axialer Richtung erstrecken, also tangential an der Mantelfläche anliegen. Beispielsweise können sich die Querwände 131 in axialer Richtung von dem Steg 102 bis zu dem Steg 104 erstrecken und/oder beispielsweise senkrecht auf den Stegen 102, 104 stehen. Die Querwände 131 können beispielsweise eine geringere Höhe haben als die Stege 102, 104. Beispielsweise können die Querwände 131 mit den Stegen 102, 104, mit der Mantelfläche des Prozesskopfes 22 und mit der zu behandelnden Oberfläche des Substrats 30 einzelne Prozessräume 100, 120 voneinander mehr oder weniger abgrenzen. Auf diese Weise können auf dem äußeren Umfang segmentierte Prozessräume 100, 120 gebildet sein, in denen nacheinander unterschiedliche Drücke erzeugt werden können und beispielsweise unterschiedliche Prozessgase zugeführt oder abgesaugt werden können. Beispielsweise können so der erste Prozessraum 100, ein zweiter Prozessraum 110, der dritte Prozessraum 120 und/oder ein vierter Prozessraum 130 ausgebildet sein. Zwischen den Prozessräumen 100, 110, 120, 130 können weitere Prozessräume gebildet sein, beispielsweise ein, zwei oder mehr fünfte Prozessräume 134 und/oder ein, zwei oder mehr sechste Prozessräume 132.

Beispielsweise können den ersten bis vierten Prozessräumen 100, 110, 120, 130 über die ersten bis vierten Gaseinlässe 50a, 50b, 50c, 50d ein erstes, ein zweites, ein drittes bzw. ein viertes Reaktionsgas zum Behandeln der Oberfläche des Substrats 30 zugeführt werden. Alternativ dazu können den ersten bis vierten Prozessräumen 100, 110, 120, 130 beispielsweise nur ein oder alternierend zwei Reaktionsgase zugeführt werden. Den fünften Prozessräumen 134 kann beispielsweise über die fünften Gaseinlässe 50e als fünftes oder weiteres Prozessgas ein Spülgas zugeführt werden. Die fünften Prozessräume 134 können in diesem Zusammenhang auch als Spülbereiche bezeichnet werden. In den sechsten Prozessräumen 132 kann beispielsweise über die Gaseinlässe 51 permanent ein Unterdruck erzeugt werden, oder zumindest ein geringerer Druck als in dem vorhergehenden Prozessraum, so dass die zuvor zugeführten Prozessgase in den sechsten Prozessräumen 132 abgesaugt werden können. Die sechsten Prozessräume 132 können in diesem Zusammenhang auch als Unterdruckbereiche bezeichnet werden. Beispielsweise kann nahe der Querwände 131, die die sechsten Prozessräume 132 begrenzen, innerhalb der sechsten Prozessräume 132 je ein Gaseinlass 51 zum Absaugen von Prozessgas angeordnet sein.

An den ersten Prozessraum 100 grenzt ein Bereich des Substrats 30, in dem eine vorgegebene Position A auf dem Substrat angeordnet ist. Somit wirkt in der in Figur 7 gezeigten Situation beispielsweise das erste Reaktionsgas in dem ersten Prozessraum 100 auf die vorgegebene Position A des Substrats. Zu einem späteren Zeitpunkt grenzt der Bereich des Substrats 30 mit der vorgegebenen Position A an einen anderen der Prozessräume, so dass ein anderes Prozessgas auf die vorgegebene Position A trifft.

**Fig. 8** zeigt ein Ausführungsbeispiel einer ersten Schichtstruktur 200, die beim Behandeln der Oberfläche des Substrats 30 erzeugt wird und mit der die Oberfläche des Substrats 30 beschichtet ist. Die erste Schichtstruktur 200 weist beispielsweise mehrere erste Schichten 210 auf, die jeweils aus dem gleichen ersten Material oder aus der gleichen ersten Materialkombination bestehen. Beispielsweise bildet jede erste Schicht 210 eine vollständige ALD-Schicht, die beispielsweise aus der Reaktion zweier Edukte entsteht und/oder die beispielsweise während einer einzigen Umdrehung des Prozesskopfes 22 gebildet wird.

**Fig. 9** zeigt ein Ausführungsbeispiel einer zweiten Schichtstruktur 202, die beim Behandeln der Oberfläche des Substrats 30 erzeugt wird und mit der die Oberfläche des Substrats 30 beschichtet ist. Die zweite Schichtstruktur 202 weist beispielsweise mehrere erste Schichten 210, die jeweils aus dem ersten Material oder aus der ersten Materialkombination bestehen, und mehrere zweite Schichten 220 auf, die jeweils aus einem zweiten Material oder aus einer zweiten Materialkombination bestehen. Die ersten und zweiten Schichten 210, 220 sind alternierend und abwechselnd nacheinander angeordnet. Beispielsweise bildet jede zweite Schicht 220 eine vollständige ALD-Schicht, die beispielsweise aus der Reaktion eines weiteren mit einem bisherigen Edukt oder aus der Reaktion zweier weiterer Edukte entsteht und/oder die beispielsweise während einer einzigen Umdrehung des Prozesskopfes 22 gebildet wird.

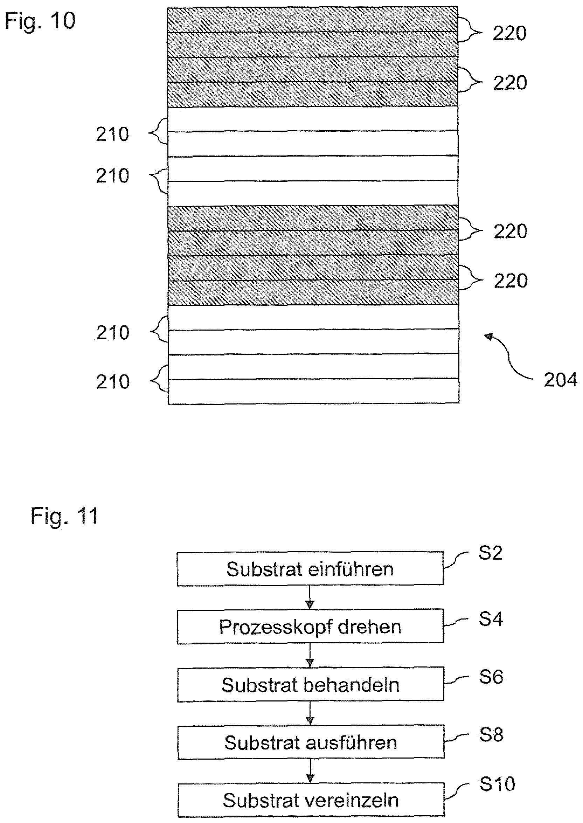

**Fig. 10** zeigt ein Ausführungsbeispiel einer dritten Schichtstruktur 204, die beim Behandeln der Oberfläche des Substrats 30 erzeugt wird und mit der die Oberfläche des Substrats 30 beschichtet ist. Die dritte Schichtstruktur 204 weist beispielsweise mehrere der ersten Schichten 210, die jeweils aus dem ersten Material oder aus der ersten Materialkombination bestehen, und mehrere der zweiten Schichten 220 auf, die jeweils aus dem zweiten Material oder aus der zweiten Materialkombination bestehen. Bei der dritten Schichtstruktur 204 sind mehrere der ersten Schichten 210, die ein erstes Schichtpaket bilden, und mehrere der zweiten Schichten 220, die ein zweites Schichtpaket bilden, nacheinander angeordnet, wobei mehrere dieser Schichtpakete alternierend und abwechselnd nacheinander angeordnet sind.

Alternativ oder zusätzlich zu den vorstehend gezeigten Schichtstrukturen 200, 202, 204 sind weitere Schichtstrukturen 200, 202, 204 denkbar, die beispielsweise Schichtstrukturen mit mehr oder weniger Schichten und/oder mit mehr oder weniger unterschiedlichen Schichten, also mit unterschiedlichen Materialien, aufweisen.

Die Funktionsweise der Vorrichtung 10 zum Behandeln der Oberfläche des Substrats 30 und die Herstellung der Schichtstrukturen 200, 202, 204 werden nachfolgend im Zusammenhang mit einem Verfahren zum Behandeln der Oberfläche des Substrats 30 näher erläutert, wobei das Verfahren beispielsweise mit Hilfe der zuvor erläuterten Vorrichtung 10 oder mit einer alternativen Vorrichtung durchgeführt werden kann. Die Schichtstrukturen 200, 202, 204 werden bei dem Verfahren zum Behandeln der Oberfläche des Substrats 30 erzeugt, was beispielsweise dazu beiträgt, das optoelektronische Bauelement herzustellen, das das Substrat 30 mit einer der Schichtstrukturen 200, 202, 204 aufweist.

**Fig. 11** zeigt ein Ablaufdiagramm eines Ausführungsbeispiels eines beispielhaften Verfahrens zum Behandeln der Oberfläche des Substrats 30. Das Verfahren kann beispielsweise mit Hilfe der vorstehend beschriebenen Vorrichtung 10 durchgeführt werden.

In einem Schritt S2 kann das Substrat 30 in die Vorrichtung 10, beispielsweise in die Prozesseinheit 20, eingeführt werden. Das Einführen des Substrats 30 in die Prozesseinheit 20 kann beispielsweise über die Zuführöffnung 78 derart erfolgen, dass sich das Substrat 30 zuerst zwischen die erste Walze 28 und das Zwischenstück 60, dann zwischen den Prozesskopf 22 und die erste Walze 28 und dann zwischen den Prozesskopf 22 und eine Innenwand des Gehäuses 24 schiebt oder geschoben wird. Dabei wird das Substrat 30 so zumindest teilweise um die Mantelfläche des Prozesskopfes 22 und gegebenenfalls auf die Stege 102, 104 gelegt, dass eine zu beschichtende Oberfläche des Substrats 30, die dem Prozesskopf 22 zugewandt ist, und die Mantelfläche des Prozesskopfes 22 und gegebenenfalls die Stege 102, 104 und gegebenenfalls die Querwände 131 die Prozessräume 100, 110, 120, 130, 132, 134 bilden.

### Spülgas bspw. Inertgas

In einem Schritt S4 wird der Prozesskopf 22 gedreht. Beispielsweise kann eine Drehfrequenz des Prozesskopfes 22 in einem Bereich zwischen 1 und 1000 U/min liegen, beispielsweise zwischen 100 u. 500 U/min, beispielsweise zwischen 150 und 250 U/min oder 200 U/min sein. Ferner kann der Prozesskopf 22 in der Rotationsrichtung 25 gedreht werden, die der Vorschubrichtung des Substrats 30 entgegengesetzt ist, oder der Rotationsrichtung 25 entgegengesetzt.

In einem Schritt S6 wird die Oberfläche des Substrats 30 behandelt. Beispielsweise kann die Oberfläche des Substrats 30 zumindest teilweise abgetragen werden oder die Oberfläche des Substrats 30 kann beschichtet werden. Beispielsweise können zum Beschichten oder Abtragen der Oberfläche des Substrats 30 über den sich drehenden Prozesskopf 22 ein, zwei oder mehr Prozessgase beispielsweise den Prozessräumen 100, 110, 120, 130, 132, 134 zugeführt bzw. aus diesen abgeführt werden. Durch das Zuführen und Abführen der Prozessgase können in den entsprechenden Prozessräumen beispielsweise Drücke von 0,001 bis 5 bar, beispielsweise von 0,01 bis 2 bar, beispielsweise von 0,1 bis 1,5 bar erzeugt werden. Bei dem Abführen der Prozessgase können in den sechsten Prozessräumen 132 beispielsweise Drücke von 0,0005 bis 4,95 bar, beispielsweise von 0,005 bis 1,95 bar, beispielsweise von 0,01 bis 1,45 bar erzeugt werden. Die genannten Druckangaben beziehen sich auf absolute Drücke. Ausschlaggebend für ein effektives Verringern oder Verhindern von einer Mischung und/oder Verschleppung der Prozessgase und/oder ein effektives Zuführen oder Abführen der Prozessgase aus dem bzw. den Prozessräumen können aber auch die Differenzdrücke zwischen den einzelnen Prozessräumen sein. Beispielsweise wenn die Prozessräume nicht diskret voneinander abgetrennt sind, sondern mehr oder weniger kontinuierlich ineinander übergehen. Ein derartiger Differenzdruck kann beispielsweise zwischen 0,001 und 1 bar, beispielsweise zwischen 0,01 und 0,1 bar, beispielsweise zwischen 0,05 und 0,08 bar betragen. Ein Differenzdruck kann beispielsweise auch ein Druckunterschied zwischen zwei Drücken an einer vorgegebenen Position, beispielsweise an der vorgegebenen Position A, auf dem Substrat 30 zu unterschiedlichen Zeitpunkten sein. Falls der Abtragungsprozess durchgeführt wird, so kann dieser beispielsweise ein Trockenätzprozess, beispielsweise chemisches Trockenätzen sein.

In einem Schritt S8 kann das Substrat 30 aus der Prozesseinheit 20 heraus geführt werden. Dabei wird das Substrat 30 zuerst zwischen den Prozesskopf 22 und die zweite Walze 28, dann zwischen die zweite Walze 28 und das Zwischenstück 60 und dann über die Abführöffnung 76 aus dem Gehäuse 24 heraus geführt.

Die Zuführung und die Abführung des Substrats 30 erfolgen beispielsweise, ohne dass das Substrat 30 vereinzelt wird, wodurch ein Roll-to-Roll Prozess möglich ist. Die Zuführung und die Abführung des Substrats 30 in bzw. aus dem Gehäuse 24 kann dabei kontinuierlich oder getaktet erfolgen. Beispielsweise kann der Vorschub des Substrats 30 während der Oberflächenbehandlung unterbrochen werden oder nicht. Beispielsweise kann der Vorschub des Substrats 30 getaktet sein, so dass nacheinander aufeinanderfolgende längliche Bereiche des Substrats 30 behandelt werden. Während eines Takts können durch Zuführen der Prozessgase und beim Beschichten durch Ablagern der entsprechenden Atome und/oder Moleküle mehrere Schichten gleichen oder unterschiedlichen Materials oder gleicher oder unterschiedlicher Materialkombinationen auf dem Substrat 30 abgeschieden werden oder beim Abtragen von diesem entfernt werden. Alternativ dazu kann das Substrat 30 kontinuierlich weitergeschoben werden, beispielsweise mit einer konstanten Vorschubgeschwindigkeit. Auch dabei können mehrere Schichten gleichen oder unterschiedlichen Materials oder gleicher oder unterschiedlicher Materialkombinationen auf dem Substrat abgeschieden oder von diesem entfernt werden, sofern die Umfangsgeschwindigkeit, das heißt die Geschwindigkeit, mit der sich beispielsweise die Gasauslässe 50 und/oder Gaseinlässe 51 bewegen, des Prozesskopfes 22 größer ist als die Vorschubgeschwindigkeit des Substrats 30. Beispielsweise können unabhängig von den vorstehend erläuterten Vorschubarten die ersten bis vierten Schichtstrukturen 200 bis 204 erzeugt werden. Eine durchschnittliche Vorschubgeschwindigkeit des Substrats 30 kann in einem Bereich zwischen 0 und 100 m/min liegen, wobei 0 m/min beispielsweise zeitweise bei getaktetem Vorschub auftreten können, beispielsweise zwischen 0,1 und 10 m/min, beispielsweise zwischen 0,5 und 5 m/min. Die Umfangsgeschwindigkeit des Prozesskopfes 22 kann größer sein als die Vorschubgeschwindigkeit des Substrats 30. Beim Anordnen mehrerer Prozessköpfe 22 hintereinander zum Behandeln desselben Substrats 30 kann die Vorschubgeschwindigkeit erhöht werden.

Bei einem Beschichtungs-Zyklus oder bei einer Umdrehung des Prozesskopfes 22 ist beispielsweise ein Schichtwachstum von 0,1 nm/cy möglich. Bei Annahme einer Drehgeschwindigkeit von 200 U/min kann somit eine ALD-Schichtdicke von 20 nm nach 60 s erreicht werden. Bei Annahme eines Prozesskopfes 22 mit Radius 11 cm ist ein Umfang der Mantelfläche 69,1 cm, wodurch sich eine Beschichtungslänge des Substrats von ca. 0,6 m ergibt. Somit ist für den Roll-to-Roll Prozess ein Schichtwachstum von 20 nm mit einer Beschichtungsgeschwindigkeit von 0,6 m/min möglich. Dabei bewegt sich einer der Prozessräume 100, 110, 120, 130 beispielsweise in 24 ms über eine vorgegebene Stelle auf dem Substrat 30.

Bei Annahme eines Prozesskopfes 22 mit einem Radius von 55 cm ergibt sich eine Beschichtungsgeschwindigkeit von 5 * 0,6 m/min, also von 3 m/min, d.h. großtechnische Produktionslinien sind realisierbar. Bei Annahme dieser Parameter können die einzelnen Prozesse abhängig von den verwendeten Precusoren teilweise bei Raumtemperatur durchgeführt werden.

In einem Schritt S10 kann das Substrat 30 mit der behandelten Oberfläche vereinzelt werden. Beispielsweise kann das behandelte Substrat 30 von der Rolle abgerollt und/oder geschnitten, gesägt oder geätzt werden.

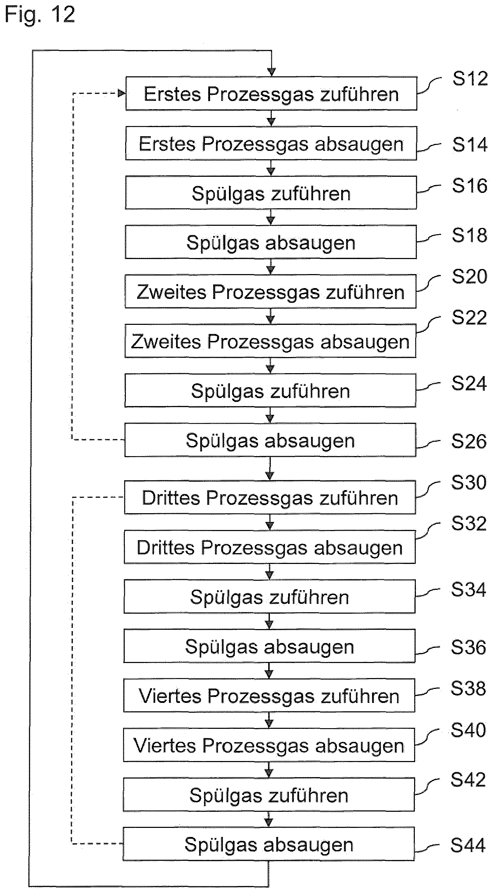

**Fig. 12** zeigt ein Ablaufdiagramm eines Ausführungsbeispiels eines Verfahrens zum Beschichten der Oberfläche des Substrats 30, das beispielsweise in dem Schritt S6 des vorstehend erläuterten Verfahrens durchgeführt werden kann. Das Beschichtungsverfahren kann beispielsweise ein CVD-Prozess oder ein ALD-Prozess sein. Beispielsweise können monoatomare oder multiatomare Schichten aufgebracht werden, die wenige Angström bis hin zu mehrere Nanometer dick sein können. Beispielsweise können 100 bis 200 gleiche oder unterschiedliche übereinanderliegende Schichten auf das Substrat 30 aufgebracht werden, beispielsweise gemäß der ersten bis dritten Schichtstrukturen 200, 202, 204.

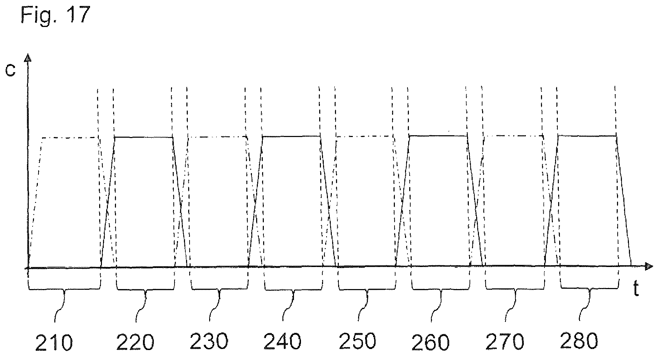

Das Ablaufdiagramm beschreibt abstrakt den Beschichtungsprozess von einer beispielhaft vorgegebenen Position auf dem Substrat 30 aus gesehen, beispielsweise von der vorgegebenen Position A aus gesehen. Die genannten Prozessräume bewegen sich während des Verfahrens über die vorgegebene Position A. Die einzelnen Schritte werden permanent ausgeführt, jedoch rotieren die Prozessräume über das Substrat 30 hinweg, so dass sich von der vorgegebenen Position A auf dem Substrat 30 aus gesehen eine zeitliche Abfolge der einzelnen Schritte ergibt. Das Ablaufdiagramm läuft daher an unterschiedlichen Positionen auf dem Substrat 30 zu unterschiedlichen Zeitpunkten ab. Ferner stellt das Verfahren einen idealisierten Prozessablauf dar, bei dem keine Verschleppung der Prozessgase von einem Prozessraum zum anderen auftritt, was beispielsweise zumindest nahezu mit Hilfe der Querwände 131 erreicht werden kann. Tatsächlich tritt jedoch auch bei Verwendung der Querwände und erst recht ohne die Querwände 131 eine Verschleppung auf, so dass beispielsweise immer beim Absaugen eines Prozessgases auch das Prozessgas des vorhergehenden Prozessraums mit abgesaugt wird und so zumindest beim Absaugen eine Vermischung der Prozessgase in der Gasphase stattfindet. Ungewünschte Reaktionen der Reaktionsgase untereinander können durch Verwendung des Spülgases immer zwischen zwei Reaktionsgasen verhindert werden, da dann beim Absaugen lediglich eine Vermischung eines der Reaktionsgase mit dem Spülgas auftritt. Der Fall, bei dem die Verschleppung mehr oder weniger auftritt, beispielsweise falls die Höhe der Querwände 131 geringer ist als die Höhe der Prozessräume oder falls auf die Querwände 131 verzichtet wird, wird weiter unten mit Bezug auf Figur 17 näher erläutert.

Falls ein ALD-Prozess durchgeführt wird, so können beispielsweise zum Erzeugen der ersten Schicht 210 über den sich drehenden Prozesskopf 22 nacheinander erst ein erstes gasförmiges Edukt, dann ein Spülgas und dann ein zweites gasförmiges Edukt zugeführt werden. Die Edukte können auch als Precusoren bezeichnet werden. Das erste Edukt kann beispielsweise Wasser aufweisen und das zweite Edukt kann beispielsweise Trimethyl-Aluminium (TMA) aufweisen, wodurch eine Al₂O₃-Schicht erzeugt werden kann. Alternativ oder zusätzlich kann als zweites Edukt beispielsweise TiCl₄ verwendet werden.

Beispielsweise kann in einem Schritt S12 das erste Prozessgas zugeführt werden, das dem ersten Edukt entspricht, beispielswiese das erste Reaktionsgas. Das erste Prozessgas kann beispielsweise dem ersten Prozessraum 100 zugeführt werden. Atome und/oder Moleküle des ersten Prozessgases können sich dabei auf der zu behandelnden Oberfläche des Substrats 30 ablagern. Beispielsweise wird die zu beschichtende Oberfläche des Substrats 30 mit den Gasatomen oder Gasmolekülen des ersten gasförmigen Edukts gesättigt. Das erste Edukt kann beispielsweise Wasserdampf, Sauerstoff oder Ozon aufweisen.

In einem Schritt S14 kann das erste Prozessgas abgesaugt werden, beispielsweise über den der Drehrichtung 25 entgegengesetzt auf den ersten Prozessraum 100 folgenden sechsten Prozessraum 132.

In einem Schritt S16 kann das Spülgas zugeführt werden, das sich mit dem restlichen ersten Prozessgas mischt. Das Spülgas kann beispielsweise dem der Drehrichtung 25 entgegengesetzt auf den ersten Prozessraum 100 folgenden fünften Prozessraum 134 zugeführt werden. Das Spülgas unterbindet weitgehend eine Mischung unterschiedlicher Edukte. In anderen Worten wird durch das Spülgas eine Vermischung der Substanzen oder Gasatome bzw. Gasmoleküle der gasförmigen Precusoren und damit eine ungewollte Gasphasenreaktion verhindert. Darüber hinaus ist dadurch eine schnelle Entfernung eines der Prozessgase bis zum Zuführen eines nächsten der Prozessgase gewährleistet. Als Spülgas kann ein Inertgas verwendet werden. Der Schritt S16 und weitere Schritte, bei denen Spülgas zugeführt wird, können allgemein auch als "purge"-Schritte bezeichnet werden.

In einem Schritt S18 kann das Spülgas mit dem restlichen ersten Prozessgas abgesaugt werden, beispielsweise über den der Drehrichtung entgegengesetzt auf den vorstehend genannten fünften Prozessraum 134 folgenden sechsten Prozessraum 132. Dabei kann in dem Prozessraum ein Unterdruck oder ein gegenüber einem angrenzenden Prozessraum vorgegebener Differenzdruck eines Betrages von beispielsweise 0,001 bis 1 bar erzeugt werden. Der Differenzdruck kann beispielsweise auch ein Druckunterschied zwischen zwei Drücken an der vorgegebenen Position A auf dem Substrat 30 zu unterschiedlichen Zeitpunkten sein.

In einem Schritt S20 kann das zweite Prozessgas zugeführt werden, das dem zweiten Edukt entspricht, beispielsweise das zweite Reaktionsgas. Das zweite Prozessgas kann beispielsweise dem zweiten Prozessraum 110 zugeführt werden. Atome und/oder Moleküle des zweiten Prozessgases können sich dabei auf der Schicht aus dem ersten Edukt ablagern und mit diesem eine Verbindung eingehen, wodurch die erste Schicht 210 gebildet ist, beispielsweise bei einer einzigen Umdrehung des Prozesskopfes 22. Dadurch kann die erste Schicht 210 beispielsweise monoatomar ausgebildet werden. Das zweite Edukt kann beispielsweise TMA sein.

In einem Schritt S22 kann das zweite Prozessgas abgesaugt werden, beispielsweise über den der Drehrichtung 25 entgegengesetzt auf den zweiten Prozessraum 110 folgenden sechsten Prozessraum 132.

In einem Schritt S24 kann das Spülgas zugeführt werden, das sich mit dem restlichen zweiten Prozessgas mischt. Das Spülgas kann beispielsweise dem der Drehrichtung 25 entgegengesetzt auf den zweiten Prozessraum 120 folgenden fünften Prozessraum 134 zugeführt werden.

In einem Schritt S26 kann das Spülgas mit dem restlichen zweiten Prozessgas abgesaugt werden, beispielsweise über den der Drehrichtung 25 entgegengesetzt auf den zuvor genannten fünften Prozessraum 134 folgenden sechsten Prozessraum 132.

Das erste und das zweite Edukt können beispielsweise mehrmals nacheinander wiederholt zugeführt werden, um mehrere Schichtenfolgen der ersten Schicht 210 zu erzeugen. Beispielsweise können die Schritte S12 bis S26 mehrmals nacheinander durchgeführt werden. Die Schritte S12 bis S26 können jeweils bei einer Umdrehung des Prozesskopfes 22 durchgeführt werden. Dies ermöglicht bei einer Umdrehung eine Schicht einer ersten ALD-Schicht aufzubringen, beispielsweise gemäß der ersten Schichtstruktur 200. Alternativ dazu können die Schritte S12 bis 26 mehrmals während einer Umdrehung durchgeführt werden, beispielsweise, indem das erste und das zweite Prozessgas über weitere der Gasauslässe 50 zugeführt werden. Dies ermöglicht bei einer Umdrehung beispielweise zwei oder mehr Schichten der ersten ALD-Schicht aufzubringen, beispielsweise gemäß der ersten Schichtstruktur 200. Ferner können dabei die eine oder die mehreren ALD-Schichten alternativ oder zusätzlich bei mehreren Umdrehungen gebildet werden.

Die Beschichtung kann beispielsweise bei dem getakteten Vorschub des Substrats 30 erfolgen. Dabei wird das Substrat 30 jeweils nur um eine Strecke weiterbefördert, die ungefähr dem Umfang des Prozesskopfes 22 entspricht, während der Beschichtung wird das Substrat 30 jedoch nicht weiter befördert. Der Prozesskopf 22 wird dann nur mit den für die jeweilige Schicht benötigten Prozessgasen versorgt, während alle anderen Prozessräume, Zuführungen und Abführungen beispielsweise mit Spülgas gespült oder abgesaugt werden. Dadurch lassen sich Schichten beliebiger Dicken realisieren.

Darüber hinaus können auch weitere gasförmige Edukte zugeführt werden, um unterschiedliche Schichten zu erzeugen. Beispielsweise können zwei oder mehr weitere Schichten während der einen oder bei weiteren Umdrehungen des Prozesskopfes 22 gebildet werden, beispielsweise gemäß der zweiten Schichtstruktur 202, und/oder es können bei nachfolgenden Umdrehungen weitere Schichten aus dem bzw. den gleichen Materialien oder Materialkombinationen gebildet werden, beispielsweise gemäß der dritten Schichtstruktur 204. Dies ermöglicht mehrere Schichten einer ersten ALD-Schicht und dann mehrere Schichten einer zweiten ALD-Schicht aufzubringen.

Beispielsweise kann in einem Schritt S30 das dritte Prozessgas zugeführt werden, das einem dritten Edukt entspricht, beispielsweise das dritte Reaktionsgas. Das dritte Prozessgas kann beispielsweise dem dritten Prozessraum 120 zugeführt werden. Atome und/oder Moleküle des dritten Prozessgases können sich dabei auf der ersten Schicht 210 ablagern. Beispielsweise wird die erste Schicht 210 mit dem dritten gasförmigen Edukt gesättigt.

In einem Schritt S32 kann das dritte Prozessgas abgesaugt werden, beispielsweise über den der Drehrichtung 25 entgegengesetzt auf den dritten Prozessraum 120 folgenden sechsten Prozessraum 132.

In einem Schritt S34 kann das Spülgas zugeführt werden, das sich mit dem restlichen dritten Prozessgas mischt. Das Spülgas kann beispielsweise dem der Drehrichtung 25 entgegengesetzt auf den dritten Prozessraum 110 folgenden fünften Prozessraum 134 zugeführt werden.

In einem Schritt S36 kann das Spülgas mit dem restlichen dritten Prozessgas abgesaugt werden, beispielsweise über den der Drehrichtung entgegengesetzt auf den zuvor genannten fünften Prozessraum 134 folgenden sechsten Prozessraum 132. Dabei kann in dem sechsten Prozessraum 132 ein Unterdruck oder ein Differenzdruck eines Betrages von beispielsweise 10 bis 100 mbar erzeugt werden.

In einem Schritt S38 kann das vierte Prozessgas zugeführt werden, das einem vierten Edukt entspricht, beispielsweise das vierte Reaktionsgas. Das vierte Prozessgas kann beispielsweise dem vierten Prozessraum 130 zugeführt werden. Atome und/oder Moleküle des vierten Prozessgases können sich dabei auf der Schicht aus dem dritten Edukt ablagern und mit diesem eine Verbindung eingehen, wodurch beispielsweise die zweite Schicht 220 gebildet ist, beispielsweise bei einer einzigen Umdrehung des Prozesskopfes 22. Dadurch kann die zweite Schicht 220 beispielsweise monoatomar ausgebildet werden.

In einem Schritt S40 kann das vierte Prozessgas abgesaugt werden, beispielsweise über den der Drehrichtung 25 entgegengesetzt auf den vierten Prozessraum 130 folgenden sechsten Prozessraum 132.

In einem Schritt S42 kann das Spülgas zugeführt werden, das sich mit dem restlichen vierten Prozessgas mischt. Das Spülgas kann beispielsweise dem der Drehrichtung 25 entgegengesetzt auf den vierten Prozessraum 130 folgenden fünften Prozessraum 134 zugeführt werden.

In einem Schritt S44 kann das Spülgas mit dem restlichen vierten Prozessgas abgesaugt werden, beispielsweise über den der Drehrichtung 25 entgegengesetzt auf den zuvor genannten fünften Prozessraum 134 folgenden sechsten Prozessraum 132.

Das dritte und das vierte Edukt können beispielsweise mehrmals nacheinander wiederholt zugeführt werden, um mehrere Schichten 220 der zweiten Schicht 220 zu erzeugen. Beispielsweise können die Schritte S30 bis S44 mehrmals nacheinander durchgeführt werden. Dies ermöglicht mehrere Schichten 220 einer zweiten ALD-Schicht aufzubringen. Ferner können die Schritte S12 bis S26 und/oder S30 bis S44 mehrmals nacheinander durchgeführt werden, um die unterschiedlichen Schichtstrukturen 200, 202, 204 aus ALD-Schichten auszubilden.

Beim Herstellen eines optoelektronischen Bauelements können die Schichten 210, 220, beispielsweise die ALD-Schichten, eine, zwei oder mehr Elektrodenschichten, organisch funktionelle Schichten, optische Schichten, wie beispielsweise Reflexionsschichten oder Transmissionsschichten, Schichten von Dünnfilmtransistoren, Barriereschichten und/oder Verkapselungsschichten bilden oder darauf gebildet sein.

In verschiedenen Ausführungsbeispielen kann die Elektrodenschicht aus einem elektrisch leitfähigen Material gebildet werden oder sein, wie beispielsweise aus einem Metall oder einem leitfähigen transparenten Oxid (transparent conductive oxide, TCO) oder einem Schichtenstapel mehrerer Schichten desselben Metalls oder unterschiedlicher Metalle und/oder desselben TCO oder unterschiedlicher TCOs. Transparente leitfähige Oxide sind transparente, leitfähige Materialien, beispielsweise Metalloxide, wie beispielsweise Zinkoxid, Zinnoxid, Cadmiumoxid, Titanoxid, Indiumoxid, oder Indium-Zinn-Oxid (ITO). Neben binären Metallsauerstoffverbindungen, wie beispielsweise ZnO, SnO2, oder In2O3 gehören auch ternäre Metallsauerstoffverbindungen, wie beispielsweise AlZnO, Zn2SnO4, CdSnO3, ZnSnO3, MgIn2O4, GaInO3, Zn2In2O5 oder In4Sn3O12 oder Mischungen unterschiedlicher transparenter leitfähiger Oxide zu der Gruppe der TCOs und können in verschiedenen Ausführungsbeispielen eingesetzt werden. Weiterhin entsprechen die TCOs nicht zwingend einer stöchiometrischen Zusammensetzung und können ferner p-dotiert oder n-dotiert sein. Ferner kann die Elektrodenschicht beispielsweise Ag, Pt, Au, Mg, Al, Ba, In, Ag, Au, Mg, Ca, Sm oder Li, sowie Verbindungen, Kombinationen oder Legierungen dieser Materialien aufweisen. Beispielsweise kann die Elektrodenschicht gebildet werden von einem Schichtenstapel einer Kombination einer Schicht eines Metalls auf einer Schicht eines TCOs, oder umgekehrt. Ein Beispiel ist eine Silberschicht, die auf einer Indium-Zinn-Oxid-Schicht (ITO) aufgebracht ist (Ag auf ITO) oder ITO-Ag-ITO Multischichten. Ferner kann die Elektrodenschicht eines oder mehrere der folgenden Materialien vorsehen alternativ oder zusätzlich zu den oben genannten Materialien: Netzwerke aus metallischen Nanodrähten und -teilchen, beispielsweise aus Ag; Netzwerke aus Kohlenstoff-Nanoröhren; Graphen-Teilchen und -Schichten; Netzwerke aus halbleitenden Nanodrähten. Ferner kann die Elektrodenschicht elektrisch leitfähige Polymere oder Übergangsmetalloxide oder elektrisch leitfähige transparente Oxide aufweisen.

In verschiedenen Ausführungsbeispielen kann eine organisch funktionelle Schicht eine oder mehrere Emitterschichten, beispielsweise mit fluoreszierenden und/oder phosphoreszierenden Emittern, enthalten, sowie eine oder mehrere Lochleitungsschichten (auch bezeichnet als Lochtransportschicht(en)) und/oder eine oder mehrere Elektronenleitungsschichten (auch bezeichnet als Elektronentransportschicht(en)). Beispiele für Emittermaterialien, die für die Emitterschicht(en) eingesetzt werden können, schließen organische oder organometallische Verbindungen, wie Derivate von Polyfluoren, Polythiophen und Polyphenylen (z.B. 2- oder 2,5-substituiertes Poly-p-phenylenvinylen) sowie Metallkomplexe, beispielsweise Iridium-Komplexe wie blau phosphoreszierendes FIrPic (Bis(3,5-difluoro-2-(2-pyridyl)phenyl-(2-carboxypyridyl)-iridium III), grün phosphoreszierendes Ir(ppy)3 (Tris(2-phenylpyridin)iridium III), rot phosphoreszierendes Ru (dtb-bpy)3*2(PF6) (Tris[4,4'-di-tert-butyl-(2,2')-bipyridin]ruthenium(III)komplex) sowie blau fluoreszierendes DPAVBi (4,4-Bis[4-(di-p-tolylamino)styryl]biphenyl), grün fluoreszierendes TTPA (9,10-Bis[N,N-di-(p-tolyl)-amino]anthracen) und rot fluoreszierendes DCM2 (4-Dicyanomethylen)-2-methyl-6-julolidyl-9-enyl-4H-pyran) als nichtpolymere Emitter ein. Ferner können Polymeremitter eingesetzt werden. Die Emittermaterialien können in geeigneter Weise in einem Matrixmaterial eingebettet sein. Es ist darauf hinzuweisen, dass andere geeignete Emittermaterialien in anderen Ausführungsbeispielen ebenfalls vorgesehen sind. Die organisch funktionelle Schicht kann allgemein eine oder mehrere funktionelle Schichten aufweisen. Die eine oder mehreren funktionellen Schichten kann oder können organische Polymere, organische Oligomere, organische Monomere, organische kleine, nicht-polymere Moleküle ("small molecules") oder eine Kombination dieser Materialien aufweisen. Beispielsweise kann die organisch funktionelle Schicht eine oder mehrere funktionelle Schichten aufweisen, die als Lochtransportschicht ausgeführt ist oder sind, so dass beispielsweise in dem Fall einer OLED eine effektive Löcherinjektion in eine elektrolumineszierende Schicht oder einen elektrolumineszierenden Bereich ermöglicht wird. Alternativ kann in verschiedenen Ausführungsbeispielen die organisch funktionelle Schicht eine oder mehrere funktionelle Schichten aufweisen, die als Elektronentransportschicht ausgeführt ist oder sind, so dass beispielsweise in einer OLED eine effektive Elektroneninjektion in eine elektrolumineszierende Schicht oder einen elektrolumineszierenden Bereich ermöglicht wird. Als Material für die Lochtransportschicht können beispielsweise tertiäre Amine, Carbazolderivate, leitendes Polyanilin oder Polyethylendioxythiophen verwendet werden. In verschiedenen Ausführungsbeispielen kann oder können die eine oder die mehreren funktionellen Schichten als elektrolumineszierende Schicht ausgeführt sein.

In verschiedenen Ausführungsbeispielen kann eine Verkapselungsschicht eines der nachfolgenden Materialien aufweisen oder daraus bestehen: Aluminiumoxid, Zinkoxid, Zirkoniumoxid, Titanoxid, Hafniumoxid, Tantaloxid Lanthaniumoxid, Siliziumoxid, Siliziumnitrid, Siliziumoxinitrid, Indiumzinnoxid, Indiumzinkoxid, Aluminiumdotiertes Zinkoxid, sowie Mischungen und Legierungen derselben. In verschiedenen Ausführungsbeispielen kann die Verkapselungsschicht oder (im Falle eines Schichtenstapels mit einer Mehrzahl von Teilschichten) eine oder mehrere der Teilschichten der Verkapselungsschicht ein oder mehrere hochbrechende Materialien aufweisen, anders ausgedrückt ein oder mehrere Materialien mit einem hohen Brechungsindex, beispielsweise mit einem Brechungsindex von mindestens 2, beispielsweise MoO₃.

In verschiedenen Ausführungsbeispielen kann eine Barriereschicht eines oder mehrere der folgenden Materialien aufweisen oder daraus bestehen: Aluminiumoxid, Zinkoxid, Zirkoniumoxid, Titanoxid, Hafniumoxid, Tantaloxid Lanthaniumoxid, Siliziumoxid, Siliziumnitrid, Siliziumoxinitrid, Indiumzinnoxid, Indiumzinkoxid, Aluminiumdotiertes Zinkoxid, sowie Mischungen und Legierungen derselben.

Als erste Precusoren und/oder erstes Reaktionsgas können beispielsweise zur Bildung von Oxiden Sauerstoffguellen, wie beispielsweise H₂O, H₂O₂, N₂O₄, N₂O, O₂, O₃, CH₃COOH, ROH (mit R gleich CH₃, CH₂OHCH₂OH, t-C₄H₉OH oder n-C₄H₉OH) oder MetallAlkoxide, zur Bildung von Nitriden Stickstoffquellen, wie beispielsweise NH₃, (CH₃)NNH₂, tBuNH₂ oder CH₂CHCH₂NH, zur Bildung von reinen Metallen beispielsweise H₂, B₂H₆, Silane oder Hydride, zur Bildung von Sulfiden, Seleniden oder Telluriden beispielsweise H₂S, H₂Se bzw. H₂Te verwendet werden.

Als zweite Precusoren und/oder zweites Reaktionsgas können beispielsweise zur Bildung von Al₂O₃ beispielsweise (CH₃)₃Al, (CH₃)₂AlCl, (CH₃)₂AlH oder (CH₃CH₂)₃Al zugeführt werden, zur Bildung von ZnO beispielsweise (CH₃)₄Zn, (CH₃CH₂)₄Zn oder (C₂H₅)₂Zn zugeführt werden, zur Bildung von ZrO₂ beispielsweise (C₅H₅)₂ZrCl₂, (C₅H₅)₂Zr(CH₃)₂, Zr[(C₂H₅)(CH₃)N]₄, ZrCl₄ oder Zr(CH₃C₅H₄)₂CH₃OCH₃ zugeführt werden, zur Bildung von TiO2/TiN beispielsweise Ti(OCH(CH₃)₂)₄, Ti[N(CH₃)₂]₄, TiCl₄ oder [(C₂H₅)₂N]₄Ti zugeführt werden, zur Bildung von HfO₂ beispielsweise (C₅H₅) ₂HfCl₂, (C₅H₅) ₂Hf (CH₃)₂, Hf[(C₂H₅)(CH₃)N]₄, HfCl₄, Hf[C₅H₄(CH₃)]₂(CH₃)₂oder HfCH₃(OCH₃)[C₅H₄(CH₃)]₂ zugeführt werden, zur Bildung von Ta₂O₅/Ta₃N₅ beispielsweise TaCl₅ oder (CH₃)₃CNTa(N(C₂H₅)₂)₃ zugeführt werden, zur Bildung von La₂O₃ beispielsweise (C₅H₅)₃La oder (C₅MeH₄)₃La zugeführt werden, zur Bildung von SiO₂/SiN beispielsweise SiCl₄, Si(O(CH₂)₃CH₃)₄, ((CH₃)₃CO)₃SiOH, (CH₃CH₂C (CH₃)₂O)₃SiOH oder (HSiCH₃O)₄ zugeführt werden, zur Bildung von SnO₂ beispielsweise (CH₃)₄Sn oder (CH₃CH₂)₄Sn zugeführt werden, zur Bildung von ITO beispielsweise In(OCCH₃CHOCCH₃)₃, (CH₃)₄Sn oder (CH₃CH₂)₄Sn zugeführt werden, zur Bildung von MgO beispielsweise (C₅H₅)₂M₉ zugeführt werden, zur Bildung von Sc₂O₃ beispielsweise (C₅H₅)₃Sc zugeführt werden, zur Bildung von Y₂O₃ beispielsweise (C₅H₅)₃Y oder (C₅MeH₄)₃Y zugeführt werden, zur Bildung von Pt beispielsweise (C₅MeH₄)PtMe₃ oder C₅H₄CH₃Pt(CH₃)₃ zugeführt werden, zur Bildung von NiO beispielsweise (C₅H₅)₂Ni oder Ni(C₅H₄C₂H₅)₂ zugeführt werden, zur Bildung von V₂O₅ beispielsweise OV(OCH(CH₃)₂)₃ zugeführt werden, zur Bildung von Fe₂O₃ beispielsweise {(CH₃)₃CO)₃Fe}₂ zugeführt werden, zur Bildung von WN beispielsweise ((CH₃)₃CN)₂W(N(CH₃)₂)₂ zugeführt werden, zur Bildung von GaAs beispielsweise (CH₃CH₂)₃Ga, Ga(CH₃)₃, (C₆H₅)₃As oder (C₆H₅)₂AsCH₂CH₂As(C₆H₅)₂ zugeführt werden, zur Bildung von ZnS beispielsweise (CH₃)₄Zn, (CH₃CH₂)₄Zn oder (C₂H₅)₂Zn zugeführt werden, zur Bildung von CdS beispielsweise Cd(C₂H₇O₂)₂ zugeführt werden, zur Bildung von B₂O₃ beispielsweise (C₆H₅)₃B oder [(CH₃)₂CHO]₃B zugeführt werden, zur Bildung von Pd beispielsweise Pd(C₅H₇O₂)₂ zugeführt werden, zur Bildung von BaO beispielsweise Ba(OCC(CH₃)₃CHCOCF₂CF₂CF₃)2 zugeführt werden, zur Bildung von SrO beispielsweise Sr(OCC(CH₃)₃CHCOCF₂CF₂CF₃)₂ oder C₂₂H₃₈O₄Sr zugeführt werden oder zur Bildung von MoO₃ können beispielsweise C₁₁H₈MoO₄, C₁₀H₁₀Cl₂MO, [(C₆H₅)₂PCH₂CH₂P(C₆H₅)₂]Mo(CO)₄, C₁₆H₁₀MO₂O₆, Mo(CO)₆, Mo(CO)₆, C₂₂H₂₂Mo₂O₆, C₇H₈Mo(CO)₃ oder Mo(NCCH₃)₃(CO)₃ zugeführt werden.

Vor dem Zuführen der Prozessgase in die Prozessräume 100, 110, 120, 130 kann in den entsprechenden Prozessräumen ein Unterdruck bis nahe dem Vakuum erzeugt werden oder nicht. Ferner können multiatomare Schichten ausgebildet werden.

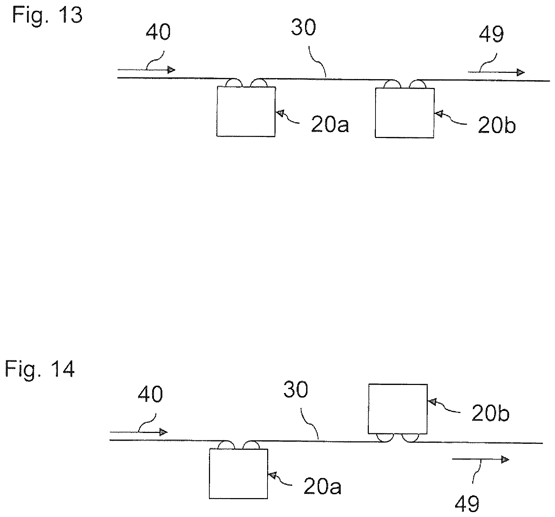

Fig. 13 zeigt ein Ausführungsbeispiel der Vorrichtung 10 zum Behandeln der Oberfläche des Substrats 30, die mehrere in Reihe angeordnete Prozesseinheiten 20 mit entsprechend in Reihe angeordneten Prozessköpfen 22 aufweist. Dass die Prozessköpfe 22 in Reihe angeordnet sind, bedeutet in diesem Zusammenhang, dass das Substrat 30 nacheinander die einzelnen Prozesseinheiten 20 an den entsprechen Prozessköpfe 22 vorbei durchläuft. Die Prozessköpfe 22 sind beispielsweise so angeordnet, dass von dem bzw. einem der nachfolgenden Prozessköpfe 22 die gleiche Seite Substrats 30 behandelt wird wie von dem vorhergehenden Prozesskopf 22. Dadurch können weitere Schichten und/oder beispielsweise alternierende Schichten oder Schichtpakete aufgebracht werden oder eine zuvor aufgebrachte Schicht kann ganz oder teilweise abgetragen werden. Alternativ oder zusätzlich bei gleich bleibender Schichtstruktur können die Schichten insgesamt schneller aufgebracht werden, beispielsweise kann die Vorschubgeschwindigkeit erhöht werden.

**Fig. 14** zeigt ein weiteres Ausführungsbeispiel der Vorrichtung 10 zum Behandeln der Oberfläche des Substrats 30, die mehrere in Reihe angeordnete Prozesseinheiten 20 mit entsprechend in Reihe angeordneten Prozessköpfen 22 aufweist. Die Prozessköpfe 22 sind beispielsweise so angeordnet, dass von dem bzw. einem der nachfolgenden Prozessköpfe 22 die andere Seite Substrats 30 und damit eine andere Oberfläche des Substrats 30 behandelt wird wie von dem vorhergehenden Prozesskopf 22. Dadurch können auf die andere Oberfläche des Substrats 30 Schichten aufgebracht werden oder eine zuvor auf die andere Seite aufgebrachte Schicht kann ganz oder teilweise abgetragen werden.

**Fig. 15** zeigt ein Ausführungsbeispiel eines Prozesskopfes, beispielsweise des Prozesskopfes 22 in Seitenansicht, wobei das Substrat 30 lediglich in Schnittansicht angedeutet ist. Bei diesem Ausführungsbeispiel des Prozesskopfes 22 sind die Querwände 131 lediglich optional angeordnet und in der Figur 15 gestrichelt dargestellt. Einer der Gasauslässe 50 und einer der Gaseinlässe 51 sind durch je eine schlitzförmige Ausnehmung ausgebildet. Darüber hinaus sind um den Umfang des Prozesskopfes 22 mehrere Abstandshalter 140 angeordnet. Die Abstandshalter 140 dienen dazu, einen Abstand des Substrats 30 von dem Prozesskopf 22 und damit eine Höhe der Prozessräume 110, 132, 134 vorzugeben. Die Abstandshalter 140 können zusätzlich oder alternativ zu den Stegen 102, 104 angeordnet sein. Außerdem können zusätzlich oder alternativ die Querwände 131 die Funktion der Abstandshalter 140 übernehmen. Bei dem in Figur 15 gezeigten Ausführungsbeispiel sind die Abstandshalter 140 kugelförmig ausgebildet und in entsprechenden Ausnehmungen des Prozesskopfes 22 drehbar gelagert, so dass im Betrieb eine Reibung zwischen den Abstandshaltern 140 und dem Substrat 30 gering gehalten werden kann. Alternativ zu der Kugelform können die Abstandshalter 140 beispielsweise auch walzenförmig ausgebildet sein und/oder sich beispielsweise parallel zu der Drehhachse 58 erstrecken, wobei die Abstandshalter 140 dann ebenfalls in entsprechenden Ausnehmungen des Prozesskopfes 22 drehbar gelagert sein können. Die Abstandshalter 140 können auch dazu beitragen, relativ breite Substrate 30 behandeln zu können.

Fig. 16 zeigt ein weiteres Ausführungsbeispiel eines Prozesskopfes, beispielsweise des Prozesskopfes 22 in Seitenansicht, wobei das Substrat 30 lediglich in Schnittansicht angedeutet ist. Bei diesem Ausführungsbeispiel des Prozesskopfes 22 weist der Prozesskopf 22 eine Mantelfläche auf, die konkav, also nach innen, gewölbt ist. Dies kann beispielsweise dazu beitragen, dass das Substrat 30 nach innen durchhängen kann und dass dennoch die gewünschte Höhe eines oder mehrerer der Prozessräume 100, 110, 132, 134 gewährleistet ist. Die Gaseinlässe 50 und/oder die Gasauslässe 51 sind bei diesem Ausführungsbeispiel beispielsweise durch kreisförmige Ausnehmungen ausgebildet. Außerdem bilden mehrere kreisförmige Ausnehmungen je einen der Gaseinlässe 50 bzw. der Gasauslässe 51. Die kreisförmigen Ausnehmungen können zusätzlich oder alternativ zu den schlitzförmigen Ausnehmungen ausgebildet sein. Ferner können mehr oder weniger und/oder größere oder kleinere Ausnehmungen ausgebildet sein. Ferner können die Ausnehmungen mit größeren oder kleineren Abständen zueinander ausgebildet sein. Unabhängig von der Form der Ausnehmungen können die Ausnehmungen selbst und/oder deren Verläufe und/oder Erstreckungen in dem Prozesskopf 22 eine Gasströmung während des Betriebs berücksichtigend ausgebildet sein. Beispielsweise können die Ausnehmungen strömungsoptimiert ausgebildet sein. Beispielsweise können die Breiten der Öffnungen der Schlitze in Richtung senkrecht zu der Achse 58 variieren.

Die Abstandshalter 140 sind beispielsweise so ausgebildet, dass das Substrat 30 von der Mantelfläche des Prozesskopfes 22 beispielsweise einen Abstand zwischen 0,01 und 10 mm, beispielsweise zwischen 0,05 und 5 mm, beispielsweise zwischen 0,1 und 1 mm hat. Der bzw. die Prozessräume haben dann bei angelegtem flexiblen Substrat 30 eine Höhe zwischen 0,01 und 10 mm, bzw. zwischen 0,05 und 5 mm, bzw. zwischen 0,1 und 1 mm.

Alternativ oder zusätzlich kann der Abstand des Substrats 30 von dem Prozesskopf 22 vorgegeben werden, indem das Substrat 30 mit Hilfe eines Unterdrucks auf der von dem Prozesskopf 22 abgewandten Seite des Substrats 30 von dem Prozesskopf 22 weggesaugt wird.

Bei allen vorstehend erläuterten Ausführungsbeispielen können die erwähnten Prozessräume mehr oder weniger voneinander abgetrennt sein. Die Abtrennung kann dabei beispielsweise mit Hilfe der Querwände 131 relativ weitgehend sein, so dass die Prozessräume beispielsweise diskret voneinander abgetrennt sind. Die Abtrennung kann jedoch auch verringert werden, beispielsweise mit abnehmender Höhe der Querwände 131. Dies kann beispielsweise soweit gehen, dass die Querwände 131 die Prozessräume nicht mehr voneinander abtrennen und/oder auf die Querwände 131 vollständig verzichtet wird. Die einzelnen Prozessräume gehen dann kontinuierlich ineinander über. Ferner sind die Prozessräume dann durch die Gaspolster gekennzeichnet und/oder definiert, in denen sich eines der Prozessgase befindet oder in denen die Prozessgase abgeführt werden. Mit geringer werdender Abtrennung nehmen eine Mischung der Prozessgase und damit eine Verschleppung der Prozessgase während des Betriebs der Vorrichtung 10 zu. Ungewünschte Reaktionen der Prozessgase miteinander aufgrund der Verschleppung können beispielsweise durch geeignete Wahl der Partialdrücke in den Prozessräumen bzw. dem gemeinsamen Prozessraum verhindert oder zumindest gering gehalten werden. Die Partialdrücke können über die Zuführung und/oder die Abführung der Prozessgase eingestellt werden. Beispielsweise kann ein Druck in dem Gehäuse 24 größer oder kleiner einem Umgebungsdruck des Gehäuses 24 sein. Beispielsweise kann ein mittlerer Druck in den Prozessräumen in etwa dem Druck in dem Gehäuse 24 entsprechen. Beispielsweise kann der mittlere Druck in den Prozessräumen zwischen 0,001 und 5 bar, beispielsweise zwischen 0,01 und 2 bar sein. Beispielsweise kann der Druck im Bereich der Gasauslässe 50 größer sein als im Bereich der Gaseinlässe 51, beispielsweise damit eine ausreichende Strömung stattfindet und/oder sich keine Anreicherung von Precusoren in Spülgasräumen, also Prozessräumen, denen Spülgas zugeführt wird, ergibt. Beispielsweise kann ein mittlerer Druck des Spülgases größer gehalten werden als ein mittlerer Druck der Precusoren. Alternativ oder zusätzlich kann ein Fluss des Spülgases größer eingestellt werden, als ein Fluss der Precusoren, wodurch beispielsweise die Verschleppung gering gehalten oder verhindert werden kann.

Fig. 17 zeigt ein Diagramm zum Veranschaulichen eines Funktionsprinzips der Vorrichtung 10 zur Oberflächenbehandlung des Substrats 30. Außerdem veranschaulicht Figur 17 die Verschleppung der Prozessgase im Betrieb der Vorrichtung 10. Insbesondere zeigt Figur 17 die Abhängigkeit der Konzentration c der Prozessgase von der Zeit t bei der vorgegebenen Position A auf dem Substrat 30. Dabei kann das Substrat 30 ortsfest sein, beispielsweise im getakteten Vorschubbetrieb, oder das Substrat 30 kann sich bewegen, beispielsweise mit einer der vorstehend genannten Vorschubgeschwindigkeiten. Während der Zeit t bewegen sich die Prozessräume über die vorgegebene Position A hinweg, so dass im zeitlichen Verlauf unterschiedliche Prozessgase in unterschiedlichen Konzentrationen über die vorgegebene Position A auf dem Substrat 30 hinweg bewegt werden. In anderen Worten werden im zeitlichen Verlauf Gaspolster, die unterschiedliche Konzentrationen von Prozessgasen aufweisen, über die vorgegebene Position A auf dem Substrat 30 hinweg bewegt. An einer anderen Position des Substrats 30, die entlang des Umfangs des Prozesskopfes 22 von der vorgegebenen Position A entfernt ist, treten die unterschiedlichen Konzentrationen ebenfalls auf, jedoch zu anderen Zeitpunkten, wobei die den einzelnen anderen Positionen entsprechenden Diagramme zu dem in Figur 17 gezeigten Diagramm zeit- und/oder phasenverschoben sind.

In einem ersten Zeitintervall 210 erhöht sich an der Position A die Konzentration c des ersten Reaktionsgases, welche als Strich-Punkt-Linie dargestellt ist, bis zu einem maximalen Wert, der dann für eine vorgegebene Zeitdauer aufrechterhalten wird. Die Zeitdauer wird im Wesentlichen von der Rotationsgeschwindigkeit des Prozesskopfes 22 vorgegeben. Während des ersten Zeitintervalls 210 bewegt sich beispielsweise der erste Prozessraum 100 über die vorgegebene Position A hinweg, wie in Figur 7 gezeigt.

An das erste Zeitintervall 210 anschließend, also zwischen dem ersten Zeitintervall 210 und einem zweiten Zeitintervall 220, wird das erste Reaktionsgas abgesaugt, beispielsweise während sich der an den ersten Prozessraum 100 anschließende sechste Prozessraum 132 über die vorgegebene Position A hinwegbewegt. Es tritt somit eine Verschleppung des ersten Reaktionsgases von dem ersten Prozessraum 100 hin zu dem darauffolgenden sechsten Prozessraum 132 auf. Darüber hinaus wird aus dem auf den sechsten Prozessraum 132 folgenden fünften Prozessraum 134 Spülgas angesaugt, was eine Verschleppung des Spülgases darstellt. Somit tritt in dem auf den ersten Prozessraum 100 folgenden sechsten Prozessraum 132 eine Vermischung des ersten Reaktionsgases und des Spülgases auf.

In dem zweiten Zeitintervall 220 ist an der Position A die Konzentration c des Spülgases maximal, welche als durchgezogene Linie dargestellt ist und welche dann für eine vorgegebene Zeitdauer aufrechterhalten wird. Die Zeitdauer wird im Wesentlichen von der Rotationsgeschwindigkeit des Prozesskopfes 22 vorgegeben. Das erste Reaktionsgas ist vollständig oder nahezu vollständig abgesaugt, so dass eine Mischung des ersten Reaktionsgases mit dem nachfolgend zuzuführenden zweiten Reaktionsgas in der Gasphase vermieden ist. Während des zweiten Zeitintervalls 220 bewegt sich beispielsweise der zwischen dem ersten und zweiten Prozessraum 100, 110 liegende fünfte Prozessraum 134 über die vorgegebene Position A hinweg.

An das zweite Zeitintervall 220 anschließend, also zwischen dem zweiten Zeitintervall 220 und einem dritten Zeitintervall 230, wird das Spülgas abgesaugt, beispielsweise während sich der vor dem zweiten Prozessraum 110 liegende sechste Prozessraum 132 über die vorgegebene Position A hinwegbewegt. Es tritt somit eine Verschleppung des Spülgases von dem fünften Prozessraum 134 hin zu dem darauffolgenden sechsten Prozessraum 132 auf. Darüber hinaus wird aus dem auf den sechsten Prozessraum 132 folgenden zweiten Prozessraum 110 das zweite Reaktionsgas angesaugt, was eine Verschleppung des zweiten Reaktionsgases darstellt. Somit tritt in dem vor dem zweiten Prozessraum 110 liegenden sechsten Prozessraum 132 eine Vermischung des zweiten Reaktionsgases und des Spülgases auf.

In dem dritten Zeitintervall 230 ist an der Position A die Konzentration c des zweiten Reaktionsgases, welche als Strich-Doppelpunkt-Linie dargestellt ist, maximal, und dann wird die maximale Konzentration c für eine vorgegebene Zeitdauer aufrechterhalten. Die Zeitdauer wird im Wesentlichen von der Rotationsgeschwindigkeit des Prozesskopfes 22 vorgegeben. Während des dritten Zeitintervalls 230 bewegt sich beispielsweise der zweite Prozessraum 110 über die vorgegebene Position A hinweg.

An das dritte Zeitintervall 230 anschließend, also zwischen dem dritten Zeitintervall 230 und einem vierten Zeitintervall 240, wird das zweite Reaktionsgas abgesaugt, beispielsweise während sich der an den zweiten Prozessraum 110 anschließende sechste Prozessraum 132 über die vorgegebene Position A hinwegbewegt. Es tritt somit eine Verschleppung des zweiten Reaktionsgases von dem zweiten Prozessraum 110 hin zu dem darauffolgenden sechsten Prozessraum 132 auf. Darüber hinaus wird aus dem auf den sechsten Prozessraum 132 folgenden fünften Prozessraum 134 Spülgas angesaugt, was eine Verschleppung des Spülgases darstellt. Somit tritt in dem auf den zweiten Prozessraum 110 folgenden sechsten Prozessraum 132 eine Vermischung des zweiten Reaktionsgases und des Spülgases auf.

Nach Ablauf des dritten Zeitintervalls 230 ist an der vorgegebenen Position A beispielsweise eine erste ALD-Schicht aufgebracht. Nachfolgend kann eine weitere ALD-Schicht an der vorgegebenen Position auf das Substrat 30 aufgebracht werden, beispielsweise eine Schicht des gleichen Materials mit Hilfe der gleichen Reaktionsgase, beispielsweise mit Hilfe des ersten und zweiten Reaktionsgases, oder eine Schicht eines anderen Materials mit Hilfe anderer Reaktionsgase, beispielsweise mit Hilfe des dritten und vierten Reaktionsgases.

In dem vierten Zeitintervall 240 ist an der Position A die Konzentration c des Spülgases maximal, welche dann für eine vorgegebene Zeitdauer aufrechterhalten wird. Die Zeitdauer wird im Wesentlichen von der Rotationsgeschwindigkeit des Prozesskopfes 22 vorgegeben. Das zweite Reaktionsgas ist vollständig oder nahezu vollständig abgesaugt, so dass eine Mischung des zweiten Reaktionsgases mit dem nachfolgend dem Substrat 30 an der vorgegebenen Position A zugeführten Reaktionsgas in der Gasphase vermieden wird. Während des vierten Zeitintervalls 240 bewegt sich beispielsweise der zwischen dem zweiten und dritten Prozessraum 110, 120 liegende fünfte Prozessraum 134 über die vorgegebene Position A hinweg.

An das vierte Zeitintervall 240 anschließend, also zwischen dem vierten Zeitintervall 240 und einem fünften Zeitintervall 250, wird das Spülgas abgesaugt, beispielsweise während sich der vor dem dritten Prozessraum 120 liegende sechste Prozessraum 132 über die vorgegebene Position A hinwegbewegt. Es tritt eine Verschleppung des Spülgases von dem fünften Prozessraum 134 hin zu dem darauffolgenden sechsten Prozessraum 132 auf. Darüber hinaus wird aus dem auf den sechsten Prozessraum 132 folgenden dritten Prozessraum 120 das sich dort befindende Prozessgas, beispielsweise das dritte Reaktionsgas angesaugt, was eine Verschleppung des dritten Reaktionsgases darstellt. Somit tritt in dem vor dem dritten Prozessraum 120 liegenden sechsten Prozessraum 132 eine Vermischung des dritten Reaktionsgases und des Spülgases auf.

In dem fünften Zeitintervall 250 erhöht sich an der Position A die Konzentration c des dritten Reaktionsgases, welche als Strich-Punkt-Linie dargestellt ist, bis zu einem maximalen Wert, der dann für eine vorgegebene Zeitdauer aufrechterhalten wird. Die Zeitdauer wird im Wesentlichen von der Rotationsgeschwindigkeit des Prozesskopfes 22 vorgegeben. Während des fünften Zeitintervalls 250 bewegt sich beispielsweise der dritte Prozessraum 120 über die vorgegebene Position A hinweg. Alternativ dazu kann in dem fünften Zeitintervall 250 an der vorgegebenen Position A auch erneut das erste Reaktionsgas zugeführt werden.

An das fünfte Zeitintervall 250 anschließend, also zwischen dem fünften Zeitintervall 210 und einem sechsten Zeitintervall 260, wird das dritte Reaktionsgas abgesaugt, beispielsweise während sich der an den dritten Prozessraum 120 anschließende sechste Prozessraum 132 über die vorgegebene Position A hinwegbewegt. Es tritt somit eine Verschleppung des dritten Reaktionsgases von dem dritten Prozessraum 120 hin zu dem darauffolgenden sechsten Prozessraum 132 auf. Darüber hinaus wird aus dem auf den sechsten Prozessraum 132 folgenden fünften Prozessraum 134 Spülgas angesaugt, was eine Verschleppung des Spülgases darstellt. Daher tritt in dem auf den dritten Prozessraum 100 folgenden sechsten Prozessraum 132 eine Vermischung des dritten Reaktionsgases und des Spülgases auf.

In dem sechsten Zeitintervall 260 ist an der Position A die Konzentration c des Spülgases maximal, welche als durchgezogene Linie dargestellt ist und dann für eine vorgegebene Zeitdauer aufrechterhalten wird. Die Zeitdauer wird im Wesentlichen von der Rotationsgeschwindigkeit des Prozesskopfes 22 vorgegeben. Das dritte Reaktionsgas ist vollständig oder nahezu vollständig abgesaugt, so dass eine Mischung des dritten Reaktionsgases mit dem vierten Reaktionsgas in der Gasphase vermieden ist. Während des sechsten Zeitintervalls 260 bewegt sich beispielsweise der zwischen dem dritten und vierten Prozessraum 120, 130 liegende fünfte Prozessraum 134 über die vorgegebene Position A hinweg.

An das sechste Zeitintervall 260 anschließend, also zwischen dem sechsten Zeitintervall 260 und einem siebten Zeitintervall 270, wird das Spülgas abgesaugt, beispielsweise während sich der vor dem vierten Prozessraum 130 liegende sechste Prozessraum 132 über die vorgegebene Position A hinwegbewegt. Es tritt somit eine Verschleppung des Spülgases von dem fünften Prozessraum 134 hin zu dem darauffolgenden sechsten Prozessraum 132 auf. Darüber hinaus wird aus dem auf den sechsten Prozessraum 132 folgenden vierten Prozessraum 130 das vierte Reaktionsgas angesaugt, was eine Verschleppung des vierten Reaktionsgases darstellt. Daher tritt in dem vor dem vierten Prozessraum 110 liegenden sechsten Prozessraum 132 eine Vermischung des vierten Reaktionsgases und des Spülgases auf.

In dem siebten Zeitintervall 270 ist an der Position A die Konzentration c des vierten Reaktionsgases, welche als Strich-Doppelpunkt-Linie dargestellt ist, maximal, und dann wird die maximale Konzentration c für eine vorgegebene Zeitdauer aufrechterhalten. Die Zeitdauer wird im Wesentlichen von der Rotationsgeschwindigkeit des Prozesskopfes 22 vorgegeben. Während des siebten Zeitintervalls 270 bewegt sich beispielsweise der dritte Prozessraum 110 über die vorgegebene Position A hinweg. Alternativ dazu kann in dem siebten Zeitintervall 270 beispielsweise erneut das zweite Reaktionsgas dem Substrat 30 an der vorgegebenen Position A zugeführt werden.

An das siebte Zeitintervall 270 anschließend, also zwischen dem siebten Zeitintervall 270 und einem achten Zeitintervall 280, wird das vierte Reaktionsgas abgesaugt, beispielsweise während sich der an den vierten Prozessraum 130 anschließende sechste Prozessraum 132 über die vorgegebene Position A hinwegbewegt. Es tritt somit eine Verschleppung des vierten Reaktionsgases von dem vierten Prozessraum 130 hin zu dem darauffolgenden sechsten Prozessraum 132 auf. Darüber hinaus wird aus dem auf den sechsten Prozessraum 132 folgenden fünften Prozessraum 134 Spülgas angesaugt, was eine Verschleppung des Spülgases darstellt. Daher tritt in dem auf den vierten Prozessraum 110 folgenden sechsten Prozessraum 132 eine Vermischung des vierten Reaktionsgases und des Spülgases auf.

Nach Ablauf des siebten Zeitintervalls 270 ist an der vorgegebenen Position A beispielsweise eine zweite ALD-Schicht aufgebracht. Nachfolgend kann eine weitere ALD-Schicht an der vorgegebenen Position A auf das Substrat 30 aufgebracht werden, beispielsweise eine Schicht des gleichen Materials mit Hilfe der gleichen Reaktionsgase, beispielsweise mit Hilfe des dritten und vierten Reaktionsgases, oder eine Schicht eines anderen Materials mit Hilfe anderer Reaktionsgase, beispielsweise mit Hilfe des ersten und zweiten Reaktionsgases.

In dem achten Zeitintervall 280 ist an der Position A die Konzentration c des Spülgases maximal, welche dann für eine vorgegebene Zeitdauer aufrechterhalten wird. Die Zeitdauer wird im Wesentlichen von der Rotationsgeschwindigkeit des Prozesskopfes 22 vorgegeben. Das vierte Reaktionsgas ist vollständig oder nahezu vollständig abgesaugt, so dass eine Mischung des vierten Reaktionsgases mit einem dem Substrat 30 an der vorgegebenen Position A nachfolgend zugeführten Reaktionsgas vermieden wird. Während des achten Zeitintervalls 280 bewegt sich beispielsweise der zwischen dem vierten und ersten Prozessraum 130, 100 liegende fünfte Prozessraum 134 über die vorgegebene Position A hinweg.

An das achte Zeitintervall 280 anschließend wird das Spülgas abgesaugt, beispielsweise während sich der vor dem ersten Prozessraum 100 liegende sechste Prozessraum 132 über die vorgegebene Position A hinwegbewegt. Es tritt somit eine Verschleppung des Spülgases von dem fünften Prozessraum 134 hin zu dem darauffolgenden sechsten Prozessraum 132 auf. Darüber hinaus wird aus dem auf den sechsten Prozessraum 132 folgenden ersten Prozessraum 100 das sich dort befindende Prozessgas, beispielsweise das erste Reaktionsgas angesaugt, was eine Verschleppung des ersten Reaktionsgases darstellt. Daher tritt in dem vor dem ersten Prozessraum 100 liegenden sechsten Prozessraum 132 eine Vermischung des ersten Reaktionsgases und des Spülgases auf.

Das in Figur 17 gezeigte Diagramm bezieht sich auf ein Ausführungsbeispiel des Prozesskopfes 22, bei dem keine Querwände 131 vorgesehen sind und die Prozessräume allein durch die entsprechenden Prozessgase und die dadurch gebildeten über die vorgegebene Position A hinwegrotierenden Gaspolster definiert sind. Obwohl keine Querwände 131 angeordnet sind, findet wie vorstehend gezeigt keine Vermischung unterschiedlicher Reaktionsgase in der Gasphase und damit keine unerwünschte Molekülbildung losgelöst von dem Substrat 30 statt. Die Reaktionen beschränkt sich alleine auf die bereits oberflächenadsorbierten Atome und/oder Moleküle der Reaktionsgase, beispielsweise der Precusoren, auf dem Substrat 30. Die auftretenden Verschleppungen und/oder Vermischungen der Reaktionsgase mit dem Spülgas können beispielsweise durch Erhöhung des Spülgasflusses und/oder durch entlang des Umfangs des Prozesskopfes 22 breitere fünfte und/oder sechste Prozessräume 134, 132 und/oder durch stärkere Absaugungen in den sechsten Prozessräumen 132 reduziert werden. Auch eine Reduzierung des Abstandes zwischen Substrat 30 und Prozesskopf 22 kann einer Verschleppung entgegenwirken. Dies kann auch zu einer Reduzierung des Prozessgasverbrauchs beitragen.

Falls die Querwände 131 angeordnet sind, kann ein ähnliches Diagramm erstellt werden, wobei sich das entsprechende Diagramm von dem gezeigten Diagramm beispielsweise zwischen den dargestellten Zeitintervallen unterscheidet. Beispielsweise findet weniger Verschleppung und/oder Mischung von Prozessgasen statt und/oder die Steigungen der Flanken der Konzentrations-Graphen ändern sich, beispielsweise abhängig von der Höhe der Querwände 131.

Die Erfindung ist nicht auf die angegebenen Ausführungsbeispiele beschränkt. Beispielsweise können zwei oder mehr Prozessköpfe 22 in einem Gehäuse 24 angeordnet sein. Ferner können weitere Prozesseinheiten 20 angeordnet sein. Beispielsweise können die in Figur 13 und Figur 14 gezeigten Vorrichtungen 10 miteinander kombiniert sein. Ferner können mehr oder weniger Prozessgase zugeführt werden und dementsprechend weitere oder weniger (unterschiedliche) Schichten, beispielsweise ALD-Schichten, ausgebildet werden. Ferner kann bei Durchführung des Roll-to-Roll Verfahren ein Bandpuffer angeordnet werden oder das Roll-to-Roll Verfahren kann ohne Bandpuffer durchgeführt werden. Die Schichtenstrukturen 200, 202, 204 können weitere oder weniger Schichten 210, 220 aufweisen. Ferner können beliebige Schichtenkombinationen erzeugt werden.

## Patentansprüche

1. Vorrichtung zur Oberflächenbehandlung eines Substrats (30), mit:
- einem um eine Drehachse (58) drehbar gelagerten Prozesskopf (22), der mehrere Gasauslässe (50) aufweist, die zumindest teilweise an einem radial äußeren Rand des Prozesskopfes (22) ausgebildet sind,
- zwei oder mehr Abstandshaltern (140) zum Vorgeben eines Abstands zwischen dem Substrat (30) und dem Prozesskopf (22), wobei die Abstandshalter (140) mindestens zwei Stege (102, 104) aufweisen, **dadurch gekennzeichnet, dass** die Stege (102, 104) benachbart zu den axial äußeren Enden der axial äußeren Ränder des Prozesskopfes (22) angeordnet und relativ zu dem Prozesskopf drehbar gelagert sind.

2. Vorrichtung nach Anspruch 1,
bei der die Gasauslässe (50) so ausgebildet und angeordnet sind, dass im Betrieb ein Prozessgas zumindest einen der Gasauslässe (50) so verlässt, dass es zumindest teilweise in einer Richtung mit einer radial gerichteten Richtungskomponente weg von dem Prozesskopf strömt.

3. Vorrichtung nach einem der vorstehenden Ansprüche, bei der der Prozesskopf (22) zylinderförmig ausgebildet ist und eine Achse und eine Mantelfläche aufweist, wobei die Achse auf der Drehachse (58) liegt, und bei der die an dem äußeren Rand angeordneten Gasauslässe (50) an der Mantelfläche ausgebildet sind.

4. Vorrichtung nach einem der vorstehenden Ansprüche, bei der an dem radial äußeren Rand des Prozesskopfes (22) mindestens ein Gaseinlass (51) ausgebildet ist.

5. Vorrichtung nach einem der vorstehenden Ansprüche, bei der mindestens ein Gasauslass (50) und/oder der mindestens eine an dem radial äußeren Rand angeordnete Gaseinlass (51) schlitzförmig und/oder kreisförmig ausgebildet sind.

6. Vorrichtung nach einem der vorstehenden Ansprüche, bei der der Prozesskopf (22) aufweist
- einen ersten Gasauslass (50a) zum Zuführen eines ersten Reaktionsgases zu einem ersten Prozessraum (100),
- einen zweiten Gasauslass (50b) zum Zuführen eines zweiten Reaktionsgases zu einem zweiten Prozessraum (110),
- einen weiteren Gasauslass (50e) zum Zuführen eines Spülgases zu einem weiteren Prozessraum (134).

7. Vorrichtung nach einem der vorstehenden Ansprüche, die ein Gehäuse (24) aufweist, in dem der Prozesskopf (22) drehbar gelagert ist und das eine Zuführöffnung (78) zum Zuführen des Substrats (30) und eine Abfuhröffnung (76) zum Abführen des Substrats (30) aufweist.

8. Vorrichtung nach Anspruch 7,
mit einer Heizvorrichtung (74), die einen Innenraum des Gehäuses (24) beheizt.

9. Vorrichtung nach einem der Ansprüche 7 oder 8, mit einer Gehäuse-Absaugung (72) zum Absaugen von Gas aus dem Gehäuse (24).

10. Vorrichtung nach einem der Ansprüche 7 bis 9,
bei der das Gehäuse (24) eine Gehäuse-Spülgaszuführung (70) aufweist zum Zuführen von Spülgas in das Gehäuse (24).

11. Vorrichtung nach einem der vorstehenden Ansprüche, mit einer Vorschubvorrichtung zum Vorschieben des Substrats (30) hin zu dem Prozesskopf (22) und zum Weiterführen des Substrats (30) weg von dem Prozesskopf (22).

12. Vorrichtung nach einem der vorstehenden Ansprüche, die an ihrem radial äußeren Rand mehrere Querwände (131) aufweist, die in radialer Richtung von dem radial äußeren Rand abstehen und die sich in einer Richtung mit einer Richtungskomponente in axialer Richtung erstrecken.

13. Vorrichtung nach einem der vorstehenden Ansprüche, bei der in dem Prozesskopf (22) von dem radial äußeren Rand beabstandet Kanäle (52, 53, 54, 55, 56, 57) ausgebildet sind, die dazu dienen, die Gasauslässe (50) und die Gaseinlässe (51) mit entsprechenden Gasdurchführungen zu verbinden.

14. Vorrichtung nach einem der vorstehenden Ansprüche, die eine Antriebseinheit (90) zum Drehen des Prozesskopfes (22) aufweist.

15. Vorrichtung nach einem der vorstehenden Ansprüche, die mehrere in Reihe angeordnete Prozessköpfe (22) aufweist.

16. Verfahren zur Oberflächenbehandlung eines Substrats (30) mit einer Vorrichtung nach einem der vorherigen Ansprüche, bei dem
- das Substrat (30) zumindest teilweise so um einen radial äußeren Rand des drehbar gelagerten Prozesskopfes (22) angelegt wird, dass eine Oberfläche des Substrats (30) dem Prozesskopf (22) zugewandt ist und dass zwischen der Oberfläche des Substrats (30) und dem Prozesskopf (22) ein Prozessraum (100, 110, 120, 130, 132, 134) gebildet wird,
- der Prozesskopf (22) relativ zu dem Substrat (30) gedreht wird,
- über den sich drehenden Prozesskopf (22) zumindest ein Prozessgas zum Behandeln der dem Prozesskopf (22) zugewandten Oberfläche des Substrats (30) dem Prozessraum (100, 110, 120, 130) zugeführt wird.

17. Verfahren nach Anspruch 16,
bei dem der Prozesskopf (22) so ausgebildet ist und bei dem das Substrat (30) so um den radial äußeren Rand des Prozesskopfes (30) gelegt wird, dass der zwischen dem radial äußeren Rand des Prozesskopfes (22) und dem Substrat (30) gebildete Prozessraum (100, 110, 120, 130, 132, 134) von dem Prozesskopf (22) und dem Substrat (30) begrenzt ist.

18. Verfahren nach einem der Ansprüche 16 oder 17, bei dem über den radial äußeren Rand des Prozesskopfes (22) ein Prozessgas abgeführt wird.

19. Verfahren nach einem der Ansprüche 16 bis 18, bei dem mit Hilfe des Prozesskopfes (22) ein Beschichtungsverfahren durchgeführt wird.

20. Verfahren nach Anspruch 19,
bei dem ein ALD-Prozess durchgeführt wird.

21. Verfahren nach Anspruch 20,
bei dem als Prozessgase über Gasauslässe (50) des sich drehenden Prozesskopfes (22) nacheinander erst ein erstes Reaktionsgas, dann ein Spülgas und dann ein zweites Reaktionsgas zugeführt werden.

22. Verfahren nach einem der Ansprüche 16 bis 21,
bei dem das Substrat (30) während der Oberflächenbehandlung angehalten wird oder weitergeführt wird.

23. Verfahren nach einem der Ansprüche 16 bis 22,
bei dem eine Umfangsgeschwindigkeit des Prozesskopfes (22) größer ist als eine Vorschubgeschwindigkeit des Substrats (30).

24. Verfahren zum Herstellen eines optoelektronischen Bauelements, das das Verfahren nach einem der Ansprüche 16 bis 23 umfasst und bei dem das Substrat (30) mit einer Elektrodenschicht, einer optisch funktionellen Schicht, einer organisch funktionellen Schicht, einer Barriereschicht und/oder einer Verkapselungsschicht beschichtet wird.

## Claims

1. Device for the surface treatment of a substrate (30), having:
- a processing head (22), which is mounted rotatably about an axis of rotation (58) and comprises multiple gas outlets (50), which are formed at least partially on a radially outer edge of the processing head (22),
- two or more spacers (140) for providing a spacing between the substrate (30) and the processing head (22), wherein the spacers (140) comprise at least two webs (102, 104), **characterized in that** the webs (102, 104) are arranged adjacent to the axially outer ends of the axially outer edges of the processing head (22) and are mounted rotatably relative to the processing head.

2. Device according to Claim 1,
in which the gas outlets (50) are formed and arranged such that, during operation, a process gas leaves at least one of the gas outlets (50) in such a way that it flows away from the processing head at least partially in a direction having a radially directed directional component.

3. Device according to either of the preceding claims, in which the processing head (22) has a cylindrical form and has an axis and a lateral surface, wherein the axis lies on the axis of rotation (58), and in which the gas outlets (50) arranged on the outer edge are formed on the lateral surface.

4. Device according to one of the preceding claims, in which at least one gas inlet (51) is formed on the radially outer edge of the processing head (22).

5. Device according to one of the preceding claims, in which at least one gas outlet (50) and/or the at least one gas inlet (51) arranged on the radially outer edge are in the form of a slit and/or circular.

6. Device according to one of the preceding claims, in which the processing head (22) comprises
- a first gas outlet (50a) for feeding a first reaction gas to a first process space (100),
- a second gas outlet (50b) for feeding a second reaction gas to a second process space (110),
- a further gas outlet (50e) for feeding a flushing gas to a further process space (134).

7. Device according to one of the preceding claims, which comprises a housing (24), in which the processing head (22) is rotatably mounted and which comprises an infeed opening (78) for feeding the substrate (30) and a discharge opening (76) for discharging the substrate (30) .

8. Device according to Claim 7,
having a heating device (74) which heats an interior space of the housing (24).

9. Device according to either of Claims 7 or 8, having a housing suction-extraction means (72) for extracting gas from the housing (24) by suction.

10. Device according to one of Claims 7 to 9, in which the housing (24) comprises a housing flushing-gas infeed (70) for feeding flushing gas into the housing (24) .

11. Device according to one of the preceding claims, having an advancement device for advancing the substrate (30) towards the processing head (22) and for guiding the substrate (30) away from the processing head (22).

12. Device according to one of the preceding claims, which comprises multiple transverse walls (131) on its radially outer edge, which protrude in the radial direction from the radially outer edge and extend in a direction having a directional component in an axial direction.

13. Device according to one of the preceding claims, in which channels (52, 53, 54, 55, 56, 57), which are spaced apart from the radially outer edge and serve to connect the gas outlets (50) and the gas inlets (51) to corresponding gas feedthroughs, are formed in the processing head (22).

14. Device according to one of the preceding claims, which comprises a drive unit (90) for rotating the processing head (22).

15. Device according to one of the preceding claims, which comprises multiple processing heads (22) arranged in series.

16. Method for the surface treatment of a substrate (30) by means of a device according to one of the preceding claims, in which
- the substrate (30) is placed at least partially around a radially outer edge of the rotatably mounted processing head (22), such that a surface of the substrate (30) faces towards the processing head (22) and a process space (100, 110, 120, 130, 132, 134) is formed between the surface of the substrate (30) and the processing head (22),
- the processing head (22) is rotated relative to the substrate (30),
- at least one process gas for treating that surface of the substrate (30) that faces towards the processing head (22) is fed to the process space (100, 110, 120, 130) via the rotating processing head (22).

17. Method according to Claim 16,
in which the processing head (22) is formed such that, and in which the substrate (30) is placed around the radially outer edge of the processing head (30) such that, the process space (100, 110, 120, 130, 132, 134) formed between the radially outer edge of the processing head (22) and the substrate (30) is delimited by the processing head (22) and the substrate (30).

18. Method according to either of Claims 16 or 17,
in which a process gas is discharged via the radially outer edge of the processing head (22).

19. Method according to one of Claims 16 to 18,
in which a coating method is carried out using the processing head (22).

20. Method according to Claim 19,
in which an ALD process is carried out.

21. Method according to Claim 20,
in which firstly a first reaction gas, then a flushing gas, and then a second reaction gas are fed in succession as process gases via gas outlets (50) in the rotating process head (22).

22. Method according to one of Claims 16 to 21,
in which the substrate (30) is brought to a stop or guided further during the surface treatment.

23. Method according to one of Claims 16 to 22,
in which a circumferential speed of the processing head (22) is greater than an advancement speed of the substrate (30).

24. Method for producing an optoelectronic component, comprising the method according to one of Claims 16 to 23 and in which the substrate (30) is coated with an electrode layer, an optically functional layer, an organically functional layer, a barrier layer and/or an encapsulating layer.

## Revendications

1. Dispositif de traitement de la surface d'un substrat (30), comprenant :
- une tête de traitement (22) supportée en rotation autour d'un axe de rotation (58) et comportant plusieurs orifices de sortie de gaz (50) qui sont réalisés au moins en partie sur un bord radialement extérieur de la tête de traitement (22),
- deux ou plusieurs entretoises (140) pour définir une distance entre le substrat (30) et la tête de traitement (22), dans lequel les entretoises (140) comportent au moins deux entretoises (102, 104), **caractérisé en ce que** les entretoises (102, 104) sont agencées de manière adjacente aux extrémités axialement extérieures des bords axialement extérieurs de la tête de traitement (22) et sont supportées en rotation par rapport à la tête de traitement.

2. Dispositif selon la revendication 1,
dans lequel les orifices de sortie de gaz (50) sont réalisés et agencés de telle sorte que, lors du fonctionnement, un gaz de traitement sorte d'au moins l'un des orifices de sortie de gaz (50) de manière à ce qu'il s'écoule au moins en partie dans une direction ayant une composante directionnelle orientée radialement en s'éloignant de la tête de traitement.

3. Dispositif selon l'une des revendications précédentes, dans lequel la tête de traitement (22) est réalisée sous forme cylindrique et comporte un axe et une surface d'enveloppe, dans lequel l'axe est situé sur l'axe de rotation (58), et dans lequel les orifices de sortie de gaz (50) agencés sur le bord extérieur sont réalisés sur la surface d'enveloppe.

4. Dispositif selon l'une des revendications précédentes, dans lequel au moins un orifice d'entrée de gaz (51) est réalisé sur le bord radialement extérieur de la tête de traitement (22).

5. Dispositif selon l'une des revendications précédentes, dans lequel ledit au moins un orifice de sortie de gaz (50) et/ou ledit au moins un orifice d'entrée de gaz (51) agencé sur le bord radialement extérieur sont réalisés en forme de fente et/ou en forme de cercle.

6. Dispositif selon l'une des revendications précédentes, dans lequel la tête de traitement (22) comporte
- un premier orifice de sortie de gaz (50a) destiné à introduire un premier gaz réactionnel dans un premier espace de traitement (100),
- un deuxième orifice de sortie de gaz (50b) destiné à introduire un deuxième gaz réactionnel dans un deuxième espace de traitement (110),
- un autre orifice de sortie de gaz (50e) destiné à introduire un gaz de purge dans un autre espace de traitement (134).

7. Dispositif selon l'une des revendications précédentes, qui comporte un boîtier (24) dans lequel la tête de traitement (22) est supportée en rotation et qui comporte un orifice d'introduction (78) destiné à introduire le substrat (30) et un orifice de déchargement (76) destiné à décharger le substrat (30).

8. Dispositif selon la revendication 7,
comprenant un dispositif de chauffage (74) qui chauffe un espace intérieur du boîtier (24).

9. Dispositif selon l'une des revendications 7 ou 8, comprenant un dispositif d'aspiration de boîtier (72) destiné à aspirer un gaz hors du boîtier (24).

10. Dispositif selon l'une des revendications 7 à 9, dans lequel le boîtier (24) comporte un dispositif d'introduction de gaz de purge du boîtier (70) destiné à introduire un gaz de purge dans le boîtier (24).

11. Dispositif selon l'une des revendications précédentes, comprenant un dispositif d'avancement destiné à faire avancer le substrat (30) vers la tête de traitement (22) et à éloigner le substrat (30) de la tête de traitement (22).

12. Dispositif selon l'une des revendications précédentes, qui comporte sur son bord radialement extérieur plusieurs parois transversales (131) qui font saillie radialement par rapport au bord radialement extérieur et qui s'étendent dans une direction ayant une composante directionnelle orientée dans la direction axiale.

13. Dispositif selon l'une des revendications précédentes, dans lequel des canaux (52, 53, 54, 55, 56, 57) espacés du bord radialement extérieur, qui servent à relier les orifices de sortie de gaz (50) et les orifices d'entrée de gaz (51) à des passages de gaz correspondants, sont réalisés dans la tête de traitement (22).

14. Dispositif selon l'une des revendications précédentes, qui comporte une unité d'entraînement (90) destinée à faire tourner la tête de traitement (22).

15. Dispositif selon l'une des revendications précédentes, qui comporte plusieurs têtes de traitement (22) agencées en série.

16. Procédé de traitement de la surface d'un substrat (30) doté d'un dispositif selon l'une des revendications précédentes, dans lequel
- le substrat (30) est placé au moins en partie autour d'un bord radialement extérieur de la tête de traitement (22) supportée en rotation de telle sorte qu'une surface du substrat (30) soit tournée vers la tête de traitement (22) et qu'un espace de traitement (100, 110, 120, 130, 132, 134) soit formé entre la surface du substrat (30) et la tête de traitement (22),
- la tête de traitement (22) est mise en rotation par rapport au substrat (30),
- au moins un gaz de traitement destiné à traiter la surface du substrat (30) tournée vers la tête de traitement (22) est introduit dans l'espace de traitement (100, 110, 120, 130) par l'intermédiaire de la tête de traitement (22) en rotation.

17. Procédé selon la revendication 16,
dans lequel la réalisation de la tête de traitement (22) et le montage du substrat (30) autour du bord radialement extérieur de la tête de traitement (30) sont tels que l'espace de traitement (100, 110, 120, 130, 132, 134) formé entre le bord radialement extérieur de la tête de traitement (22) et le substrat (30) soit délimité par la tête de traitement (22) et le substrat (30).

18. Procédé selon l'une des revendications 16 ou 17, dans lequel un gaz de traitement est évacué par l'intermédiaire du bord radialement extérieur de la tête de traitement (22).

19. Procédé selon l'une des revendications 16 à 18, dans lequel un procédé de revêtement est mis en œuvre à l'aide de la tête de traitement (22).

20. Procédé selon la revendication 19,
dans lequel un procédé ALD est mis en œuvre.

21. Procédé selon la revendication 20,
dans lequel un premier gaz réactionnel, puis un gaz de purge, puis un deuxième gaz réactionnel sont introduits successivement en tant que gaz de traitement par l'intermédiaire d'orifices de sortie de gaz (50) de la tête de traitement (22) en rotation.

22. Procédé selon l'une des revendications 16 à 21, dans lequel on arrête ou on continue à faire avancer le substrat (30) pendant le traitement de surface.

23. Procédé selon l'une des revendications 16 à 22, dans lequel une vitesse périphérique de la tête de traitement (22) est supérieure à une vitesse d'avancement du substrat (30).

24. Procédé de fabrication d'un dispositif optoélectronique comprenant le procédé selon l'une des revendications 16 à 23 et dans lequel le substrat (30) est revêtu d'une couche d'électrode, d'une couche à fonction optique, d'une couche à fonction organique, d'une couche barrière et/ou d'une couche d'encapsulation.
